# EUROPEAN PATENT APPLICATION

(11) **EP 4 668 271 A1**
(43) Date of publication of application: **24.12.2025**
(21) Application number: 25183242.4
(22) Date of filing: 17.06.2025
(51) Int. Cl.: G11C 7/12, G11C 8/10, G11C 11/408, G11C 11/4094

(54) **MEMORY DEVICE AND MEMORY MODULE INCLUDING THE SAME**

(30) Priority: 20.06.2024 KR 20240080559; 14.11.2024 KR 20240162505
(71) Applicant: Samsung Electronics Co., Ltd., Suwon-si, Gyeonggi-do 16677 (KR)
(72) Inventor: SHIN, Hoon, 16677 Suwon-si (KR); KIM, Ki-Heung, 16677 Suwon-si (KR); SEOL, Hoseok, 16677 Suwon-si (KR); SHIN, Minchur, 16677 Suwon-si (KR); CHOI, Jinyong, 16677 Suwon-si (KR)
(74) Representative: Marks & Clerk LLP

(57) **Abstract**

Disclosed is a memory device which includes a bank array including a plurality of memory cells, a row decoder connected to the bank array through a plurality of word lines, and a column decoder connected to the bank array through a plurality of column selection lines. The bank array includes a first region and a second region different from the first region. The memory device is configured to operate in a first mode, in which the first region stores normal data and the second region stores metadata based on a first number of column addresses, respectively. The memory device is configured to operate in a second mode, in which the first region and the second region store normal data based on a second number of column addresses. The second number is greater than the first number.

## Description

### BACKGROUND

Embodiments of the present disclosure described herein relate to a memory device and a memory module including the same.

A memory device is used to store data and is classified as a volatile memory device or a nonvolatile memory device. The volatile memory device refers to a memory device which loses data stored therein when a power is turned off. As the volatile memory device, a dynamic random access memory (DRAM) is used in various fields such as a mobile system, a server, and a graphics device.

### SUMMARY

Embodiments of the present disclosure provide a memory device providing metadata efficiently.

In a first aspect there is provided a memory device including a bank array including a plurality of memory cells, a row decoder connected to the bank array through a plurality of word lines, and a column decoder connected to the bank array through a plurality of column selection lines. The bank array includes a first region and a second region different from the first region. The memory device is configured to operate in a first mode, in which the first region stores normal data and the second region stores metadata based on a first number of column addresses, respectively. The memory device is configured to operate in a second mode, in which the first region and the second region store normal data based on a second number of column addresses. The second number is greater than the first number.

Also, the first region may include a plurality of first column blocks, the second region may include at least one second column block, each of the plurality of first column blocks may include first column selection lines as many as the first number of column addresses, and each of the at least one second column block may include second column selection lines as many as a third number being equal to or greater than the first number of column addresses.

In addition, in the first mode, the column decoder, in response to receiving one column address among the first number of column addresses, may select a column selection line corresponding to the received column address in each of the plurality of first column blocks and each of the at least one second column block.

Furthermore, in the second mode, the column decoder, in response to receiving one column address among the second number of column addresses, may select a column selection line corresponding to the received column address in each of remaining first column blocks other than some of the plurality of first column blocks and each of the at least one second column block, and the some of the plurality of first column blocks may include a first column block not including the column selection line corresponding to the received column address.

Besides, the first number of first column selection lines included in each of the plurality of first column blocks may correspond to the first number of column addresses in the first mode, and the first number of second column selection lines among the third number of second column selection lines included in each of the at least one second column block may correspond to the first number of column addresses in the first mode.

Also, in the second mode, the second number of column selection lines corresponding to the second number of column addresses may include the first number of first column selection lines and a fourth number of second column selection lines, and the fourth number may be a difference between the second number and the first number.

In addition, in the second mode, the fourth number of column addresses not corresponding to the first number of first column selection lines from among the second number of column addresses may differ for every first column block.

Furthermore, the memory device may further include a plurality of first multiplexer circuits respectively corresponding to the plurality of first column blocks, and at least one second multiplexer circuit respectively corresponding to the at least one second column block. Each of the at least one second multiplexer circuit may be connected to a second global input/output line connected to the corresponding second column block, and each of the plurality of first multiplexer circuits may be connected to a first global input/output line connected to the corresponding first column block and the second global input/output line.

Besides, in the second mode, each of the plurality of first multiplexer circuits, in response to receiving one column address among the second number of column addresses, may select one of the first and second global input/output lines connected to a corresponding first multiplexer circuit, based on the received column address.

Also, the memory may further include a plurality of first multiplexer circuits respectively corresponding to the plurality of first column blocks, and at least one second multiplexer circuit respectively corresponding to the at least one second column block. Each of the at least one second multiplexer circuit may be connected to a second global input/output line connected to the corresponding second column block, at least one first multiplexer circuit among the plurality of first multiplexer circuits may be connected to a first global input/output line connected to the corresponding first column block and the second global input/output line, and each of remaining first multiplexer circuits other than the at least one first multiplexer circuit among the plurality of first multiplexer circuits may be connected to a first global input/output line connected to the corresponding first column block and a first global input/output line connected to an adjacent first column block.

In addition, in the second mode, each of the plurality of first multiplexer circuits, in response to receiving one column address among the second number of column addresses, may select one of global input/output lines connected to a corresponding first multiplexer circuit, based on the received column address.

Furthermore, the memory device may further include a mode register for setting the first mode or the second mode.

Besides, the bank array may further include a third region configured to store parity data for error correction.

Also, the first region and the second region may be connected in common to the plurality of word lines.

There is further provided, a memory device including a bank array including a first region and a second region, a row decoder connected to the first region and the second region through a plurality of word lines disposed to cross the first region and the second region, and a column decoder connected to the first region through column selection lines disposed in the first region and connected to the second region through column selection lines disposed in the second region. The memory device is configured to operate in a first mode, in which the first region stores normal data and the second region stores metadata based on a first number of column addresses, respectively. The memory device is configured to operate in a second mode, in which the first region and the second region may store normal data based on a second number of column addresses, and the second number is greater than the first number.

Also, the first region may include a plurality of first column blocks each including first column selection lines as many as the first number of column addresses, the second region may include at least one second column block each including a third number of second column selection lines, and the third number may be equal to or greater than the first number of column addresses.

In addition, the first number of first column selection lines included in each of the plurality of first column blocks may respectively correspond to the first number of column addresses in the first mode, and the first number of second column selection lines among the third number of second column selection lines included in each of the at least one second column block may respectively correspond to the first number of column addresses in the first mode.

Furthermore, in the second mode, the second number of column selection lines corresponding to the second number of column addresses may include the first number of first column selection lines and a fourth number of second column selection lines, and the fourth number may be a difference between the second number and the first number.

Besides, in the second mode, the fourth number of column addresses not corresponding to the first number of first column selection lines from among the second number of column addresses may differ for every first column block.

According to an embodiment, a memory module may include a plurality of memory devices. Each of the plurality of memory devices may include a bank array including a plurality of memory cells, a row decoder connected to the bank array through a plurality of word lines, and a column decoder connected to the bank array through a plurality of column selection lines. The bank array may include a first region and a second region different from the first region. One of the plurality of memory devices may be configured to operate in a first mode, in which the first region may store normal data and the second region may store metadata based on a first number of column addresses, respectively. The one of the plurality of memory devices may be configured to operate in a second mode, in which each of the first and second regions may store normal data based on a second number of column addresses, and the second number may be greater than the first number.

At least some of the above and other features of the invention are set out in the claims.

### BRIEF DESCRIPTION OF THE FIGURES

The above and other objects and features of the present disclosure will become apparent by describing in detail embodiments thereof with reference to the accompanying drawings.
FIG. 1 is a block diagram illustrating a memory system according to an embodiment of the present disclosure.
FIG. 2 is a block diagram illustrating a configuration of a memory device according to an embodiment of the present disclosure.
FIG. 3 is a diagram illustrating an example of a bank array according to an embodiment of the present disclosure.
FIG. 4 is a diagram for describing a bank structure of a typical memory device not supporting metadata.
FIG. 5 is a diagram illustrating a bank structure of a memory device according to an embodiment of the present disclosure.
FIG. 6 is a diagram for describing a mapping relationship between column selection lines and column addresses according to an embodiment of the present disclosure.
FIG. 7 is a diagram for describing a mapping relationship between column selection lines and column addresses according to an embodiment of the present disclosure.
FIG. 8 is a table illustrating a mapping relationship between column selection lines and column addresses according to an embodiment of the present disclosure.
FIG. 9 is a diagram for describing a configuration and an operation of multiplexer circuits according to embodiments of the present disclosure.
FIG. 10 is a diagram for describing a configuration and an operation of multiplexer circuits according to embodiments of the present disclosure.
FIG. 11 is a diagram for describing a mapping relationship between column selection lines and column addresses according to an embodiment of the present disclosure.
FIG. 12 is a diagram illustrating a bank structure according to an embodiment of the present disclosure.
FIG. 13 is a table illustrating a mapping relationship between column selection lines and column addresses according to an embodiment of the present disclosure.
FIG. 14 is a diagram illustrating a bank structure of a memory device according to an embodiment of the present disclosure.
FIG. 15 is a diagram for describing a configuration and an operation of multiplexer circuits according to embodiments of the present disclosure.
FIG. 16 is a diagram for describing a mapping relationship between column selection lines and column addresses according to an embodiment of the present disclosure.
FIG. 17 is a diagram for describing a mapping relationship between column selection lines and column addresses according to an embodiment of the present disclosure.
FIG. 18 is a diagram illustrating a memory module according to an embodiment of the present disclosure.
FIG. 19 is a diagram illustrating a memory module according to an embodiment of the present disclosure.
FIG. 20 is a diagram illustrating an example of a memory module according to an embodiment of the present disclosure.
FIG. 21 is a diagram illustrating an example of a memory module according to an embodiment of the present disclosure.

### DETAILED DESCRIPTION

In the present disclosure, when it is mentioned that one component (e.g., a first component) is "coupled with/to or connected to" another component (e.g., a second component), it may be understood that this includes not only the case where the first component is directly connected to the second component but also the case where the first component is connected to the second component through another component (e.g., a third component).

Below, embodiments of the present disclosure will be described in detail and clearly to such an extent that one skilled in the art easily carries out the present disclosure.

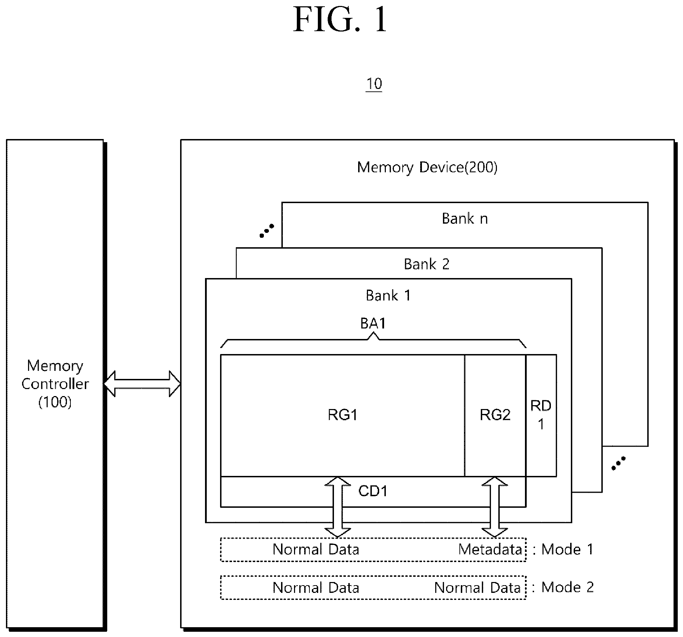

FIG. 1 is a block diagram illustrating a memory system according to an embodiment of the present disclosure.

A memory system 10 according to embodiments of the present disclosure supports a first mode Mode 1 and a second mode Mode 2.

The first mode Mode 1 refers to a mode in which normal data and metadata corresponding to the normal data are together stored in a memory device 200 and are together read from the memory device 200. Because the metadata are input/output together with the normal data, for example, the first mode Mode 1 is called a "meta ON mode".

The second mode Mode 2 refers to a mode in which only normal data are stored in the memory device 200 and are read from the memory device 200. Because the metadata are not input/output, for example, the second mode Mode 2 is called a "meta OFF mode".

To this end, the memory device 200 according to embodiments of the present disclosure can operate in the first mode Mode 1 and the second mode Mode 2. For example, the memory device 200 may include a plurality of banks Bank 1 to Bank n, and a bank array included in at least one bank among the banks Bank 1 to Bank n includes a first region RG1 and a second region RG2. In this case, the memory device 200 may operate in the first mode Mode 1 or the second mode Mode 2 based on the first region RG1 and the second region RG2.

In detail, in the first mode Mode 1, the memory device 200 may store the normal data and the metadata corresponding to the normal data in the first region RG1 and the second region RG2, respectively. In this case, the read operation or the write operation may be simultaneously performed in the first region RG1 and the second region RG2. Accordingly, in the first mode Mode 1, the normal data and the metadata corresponding to the normal data may be respectively output from the first region RG1 and the second region RG2 through one read operation. Also, in the first mode Mode 1, the normal data and the metadata corresponding to the normal data may be respectively stored in the first region RG1 and the second region RG2 through one write operation. In the read operation or the write operation, the first number of column addresses may be used in the first mode Mode 1.

Meanwhile, in the second mode Mode 2, the memory device 200 may store the normal data in both the first region RG1 and the second region RG2. In this case, the read operation or the write operation may be simultaneously performed in the first region RG1 and the second region RG2. Accordingly, in the second mode Mode 2, the normal data may be output from each of the first region RG1 and the second region RG2 through one read operation. Also, in the second mode Mode 2, the normal data may be stored in each of the first region RG1 and the second region RG2 through one write operation. In the read operation or the write operation, the second number of column addresses, which is more than the first number of column addresses, may be used in the second mode Mode 2.

In the case of a general technology, the normal data and the metadata corresponding to the normal data are provided by making the read time of the normal data different from the read time of the metadata or by using a method of adding memory cells for metadata to an existing bank array.

In the case where the read times are set to be different from each other, because two read operations are required to provide the normal data and the metadata corresponding to the normal data, the read command is added, and bus efficiency is reduced. Also, in the case where memory cells for metadata are added, the chip size overhead occurs, and power consumption due to the increase in a page size increases.

In contrast, the bank array of the memory device 200 according to an embodiment of the present disclosure may be divided into the first region RG1 and the second region RG2 as described above, and the second region RG2 may be used for different purposes depending on a mode.

In detail, assuming a bank array with a given page size, in the case of the general technology, because separate memory cells for metadata are added to the bank array to provide metadata, the page size of the bank array increases. However, according to an embodiment of the present disclosure, the bank array with the given page size may include the first region RG1 and the second region RG2; in the first mode Mode 1, the second region RG2 may be used for metadata, and thus, the metadata may be provided without the increase in the chip size overhead and the page size.

Also, according to an embodiment of the present disclosure, in the first mode Mode 1, because the read operation is simultaneously performed in the first region RG1 and the second region RG2, the normal data and the metadata corresponding to the normal data may be simultaneously provided through one read operation. Accordingly, there is no need to add a separate read command for providing the metadata, and the reduction of the bus efficiency is prevented.

Meanwhile, according to an embodiment of the present disclosure, in the second mode Mode 2, both the first region RG1 and the second region RG2 may be used for normal data. That is, the second region RG2 which is used for metadata in the first mode Mode 1 may be used for normal data in the second mode Mode 2.

Accordingly, a normal data storage capacity of the memory device 200 operating in the second mode Mode 2 may be greater than a normal data storage capacity of the memory device 200 operating in the first mode Mode 1. In this case, the memory device 200 operating in the second mode Mode 2 may perform the read or write operation on the normal data by using the second number of column addresses, which is more than the first number of column addresses used in the first mode Mode 1.

For example, assuming that the storage capacity of the first region RG1 and the second region RG2 of the bank array is 1 Gb (Gigabit), because the second region RG2 is used for metadata in the first mode Mode 1, the bank array may store the normal data whose capacity is smaller than 1 Gb. However, because the first region RG1 and the second region RG2 are used for normal data in the second mode Mode 2, the bank array may store the normal data of 1 Gb. Accordingly, the user which does not use the metadata may use the memory device 200 without the loss of the storage capacity for the normal data by setting the memory device 200 to operate in the second mode Mode 2.

According to the above embodiment of the present disclosure, the memory device 200 operating in the first mode Mode 1 or the second mode Mode 2 may be provided without the reduction of bus efficiency or the increase in power consumption. Accordingly, it may be possible to provide the metadata efficiently.

The description will be given in detail with reference to FIG. 1. Referring to FIG. 1, the memory system 10 may include a memory controller 100 and the memory device 200.

The memory controller 100 may control the memory device 200. For example, the memory controller 100 may control the memory device 200 depending on a request of a processor supporting various applications such as a server application, a personal computer (PC) application, and a mobile application. For example, the memory controller 100 may be included in a host including a processor and may control the memory device 200 depending on a request of the processor.

To control the memory device 200, the memory controller 100 may transmit a command and/or an address to the memory device 200. Also, the memory controller 100 may transmit data to the memory device 200 or may receive data from the memory device 200.

The memory device 200 may receive data from the memory controller 100 and may store the received data. In response to a request of the memory controller 100, the memory device 200 may read the stored data and may transmit the read data to the memory controller 100.

In an embodiment, the memory device 200 may be a memory device including volatile memory cells. For example, the memory device 200 may include various dynamic random access memory (DRAM) devices such as a double data rate synchronous DRAM (DDR SDRAM), a DDR2 SDRAM, a DDR3 SDRAM, a DDR4 SDRAM, a DDR5 SDRAM, a DDR6 SDRAM, a low power double data rate (LPDDR) SDRAM, an LPDDR2 SDRAM, an LPDDR3 SDRAM, an LPDDR4 SDRAM, an LPDDR4X SDRAM, an LPDDR5 SDRAM, a graphics double data rate synchronous graphics random access memory (GDDR SGRAM), a GDDR2 SGRAM, a GDDR3 SGRAM, a GDDR4 SGRAM, a GDDR5 SGRAM, and a GDDR6 SGRAM.

Also, in an embodiment, the memory device 200 may be a stacked memory device, in which DRAM dies are stacked, such as a high bandwidth memory (HBM), an HBM2, an HBM3, or an HBM4.

In addition, in an embodiment, the memory device 200 may be a memory module such as a dual in-line memory module (DIMM). For example, the memory device 200 may be included in a registered DIMM (RDIMM), a load reduced DIMM (LRDIMM), an unbuffered DIMM (UDIMM), a fully buffered DIMM (FB-DIMM), or a small outline DIMM (SO-DIMM). However, this is provided as an example, and the memory device 200 may be included in any other memory module such as a single in-line memory module (SIMM).

Also, in an embodiment, the memory device 200 may be an SRAM device, a NAND flash memory device, a NOR flash memory device, an RRAM device, an FRAM device, a PRAM device, a TRAM device, an MRAM device, etc.

The memory device 200 may include a plurality of banks Bank 1 to Bank n.

Each of the plurality of banks Bank 1 to Bank n may include a bank array, a row decoder, and a column decoder. For example, the first bank Bank 1 may include a first bank array BA1, a first row decoder RD1, and a first column decoder CD1.

Each of a plurality of bank arrays BA1 to BAn may include memory cells for storing data. The row decoder may enable a selected word line among a plurality of word lines based on a row address. The column decoder may enable a selected column selection line among a plurality of column selection lines based on a column address.

For convenience of description, in the specification, it is assumed that each bank array includes DRAM cells. However, this is provided as an example, and each bank array may be implemented to include any other volatile memory cells except for the DRAM cells. Alternatively, each bank array may be implemented to include the same kind of memory cells or may be implemented to include different kinds of memory cells.

According to an embodiment, at least one of the plurality of bank arrays BA1 to BAn includes the first region RG1 and the second region RG2. In this case, the first region RG1 may store the normal data in both the first mode Mode 1 and the second mode Mode 2. The second region RG2 may store the metadata in the first mode Mode 1 and may store the normal data in the second mode Mode 2.

Herein, the metadata which are data associated with the normal data may be used for the improvement of performance of the memory device 200 or for the reinforcement of security. For example, the metadata may be parity data which are used by the memory controller 100 for the error correction operation on the corresponding normal data. As another example, the metadata may include information about a type, a length, and an attribute of the corresponding normal data, but the present disclosure is not limited thereto.

Meanwhile, an example in which the second region RG2 is disposed on a right side of the first region RG1 is illustrated in FIG. 1, but an embodiment is not limited thereto. For example, the second region RG2 may be disposed on a left side of the first region RG1 or may be disposed between the first region RG1 and the first region RG1.

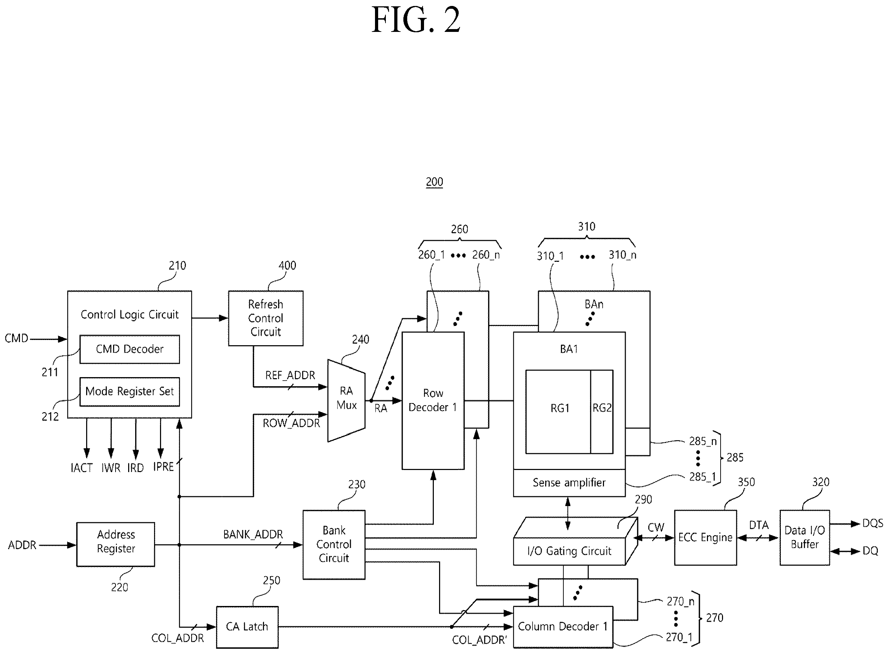

FIG. 2 is a block diagram illustrating a configuration of a memory device according to an embodiment of the present disclosure. The memory device 200 of FIG. 2 may correspond to the memory device 200 of FIG. 1.

Referring to FIG. 2, the memory device 200 may include a control logic circuit 210, an address register 220, a bank control circuit 230, a refresh control circuit 400, a row address multiplexer 240, a column address latch 250, a row decoder group 260, a column decoder group 270, a memory cell array 310, a sense amplifier unit 285, an input/output gating circuit 290, an ECC engine 350, and a data input/output buffer 320.

The memory cell array 310 may include a plurality of bank arrays 310_1 to 310_n. Each of the plurality of bank arrays 310_1 to 310_n may include a plurality of memory cells. For example, each of the plurality of memory cells may be formed at an intersection of a corresponding word line and a corresponding bit line.

The row decoder group 260 may include a plurality of row decoders 260_1 to 260_n. Each of the plurality of row decoders 260_1 to 260_n may be connected to the corresponding bank array among the plurality of bank arrays 310_1 to 310_n.

The sense amplifier unit 285 may include a plurality of sense amplifiers 285_1 to 285_n. Each of the plurality of sense amplifiers 285_1 to 285_n may be connected to the corresponding bank array among the plurality of bank arrays 310_1 to 310_n.

The column decoder group 270 may include a plurality of column decoders 270_1 to 270_n. Each of the plurality of column decoders 270_1 to 270_n may be connected to the corresponding bank array among the plurality of bank arrays 310_1 to 310_n through column selection lines.

According to an embodiment of the present disclosure, each of the plurality of bank arrays 310_1 to 310_n may include the first region RG1 and the second region RG2. When the memory device 200 operates in the first mode Mode 1, the normal data and the metadata may be respectively stored in the first region RG1 and the second region RG2. When the memory device 200 operates in the second mode Mode 2, the normal data may be stored in each of the first region RG1 and the second region RG2.

To this end, the first region RG1 may include a plurality of first column blocks, and the second region RG2 may include at least one second column block. Also, each of the plurality of first column blocks may include the first number of first column selection lines, and each of the at least one second column block may include the third number of second column selection lines, which is equal to or more than the first number.

The bank array may be divided into a plurality of regions each including the given number (e.g., the first number or the third number) of column selection lines, and each region may be used as a column block. One column block may include the given number of column selection lines and the region of the bank array corresponding thereto. In this case, the given number of column selection lines may be column selection lines physically adjacent to each other, but an embodiment is not limited thereto.

According to an embodiment, the memory device 200 operates based on column addresses, the number of which is differently set depending on an operation mode. The memory device 200 operates based on the first number of column addresses in the first mode Mode 1 and operates based on the second number of column addresses, which is more than the first number, in the second mode Mode 2. To this end, the column selection lines of the bank array may be mapped (or allocated) to column addresses in a manner variable depending on the operation mode of the memory device 200.

For example, when the memory device 200 operates in the first mode Mode 1, the first number of column addresses may be mapped to every first column block and may be mapped to every second column block. In detail, the first number of first column selection lines included in each of the first column blocks may correspond to the first number of column addresses, and the first number of second column selection lines among the third number of second column selection lines included in each of the second column blocks may correspond to the first number of column addresses.

In this case, when one of the first number of column addresses is applied, the column decoder corresponding to the bank array may select a column selection line corresponding to the applied column address in each of the plurality of first column blocks and each of the at least one second column block.

Meanwhile, when the memory device 200 operates in the second mode Mode 2, the second number of column addresses may be mapped to some of the first column block and the second column block. According to an embodiment, the first number of column addresses among the second number of column addresses may correspond to the first number of first column selection lines. Also, the fourth number of column addresses not corresponding to the first number of first column selection lines from among the second number of column addresses may correspond to the fourth number of second column selection lines included in the at least one second column block. In this case, the second number of column selection lines corresponding to the second number of column addresses may include the first number of first column selection lines and the fourth number of second column selection lines.

Herein, the fourth number may correspond to a difference between the second number and the first number. Also, the fourth number of column addresses not corresponding to the first number of first column selection lines from among the second number of column addresses may differ for every first column block.

In this case, when one of the second number of column addresses is applied, the column decoder corresponding to the bank array may select a column selection line corresponding to the applied column address in each of the remaining first column blocks other than some of the plurality of first column blocks and each of the at least one second column block. In this case, the some of the plurality of first column blocks may include a first column block not including a column selection line corresponding to the applied column address.

In an embodiment, when the first number is 60 and each of the second number and the third number is 64, the memory device 200 may operate based on 60 column addresses in the first mode Mode 1 and may operate based on 64 column addresses in the second mode Mode 2.

In detail, when the memory device 200 operates in the first mode Mode 1, the 60 column addresses may be mapped to every first column block and may be mapped to every second column block. That is, 60 first column selection lines included in each of the first column blocks may respectively correspond to the 60 column addresses, and 60 second column selection lines among 64 second column selection lines included in each of the at least one second column block may respectively correspond to the 60 column addresses.

In this case, when one of the 60 column addresses is applied, the column decoder may select a column selection line corresponding to the applied column address in each of the plurality of first column blocks and each of the at least one second column block.

Meanwhile, when the memory device 200 operates in the second mode Mode 2, 64 column selection lines corresponding to the 64 column addresses may include 60 first column selection lines and 4 second column selection lines. In this case, 4 column addresses not corresponding to the 60 first column selection lines from among the 64 column addresses may differ for every first column block.

In this case, when one of the 64 column addresses is applied, the column decoder may select a column selection line corresponding to the applied column address in each of the remaining first column blocks other than some of the plurality of first column blocks and each of the at least one second column block. Herein, the some of the plurality of first column blocks may include a first column block not including a column selection line corresponding to the applied column address.

The above examples are provided as an example; of course, the first number, the second number, and the third number are not limited thereto. According to an embodiment, the third number may be equal to the second number or may be less than the second number and may be equal to the first number or may be more than the first number. However, in some cases, the second number may be more than the first number.

The address register 220 may receive an address ADDR including a bank address BANK_ADDR, a row address ROW_ADDR, and a column address COL_ADDR from the memory controller 100. The address register 220 may provide the received bank address BANK_ADDR to the bank control circuit 230, may provide the received row address ROW_ADDR to the row address multiplexer 240, and may provide the received column address COL_ADDR to the column address latch 250.

The bank control circuit 230 may generate bank control signals in response to the bank address BANK_ADDR. For example, a row decoder corresponding to the bank address BANK_ADDR from among the plurality of row decoders 260_1 to 260_n may be activated in response to the bank control signals. A column decoder corresponding to the bank address BANK_ADDR from among the plurality of column decoders 270_1 to 270_n may be activated in response to the bank control signals.

The row address multiplexer 240 may receive the row address ROW_ADDR from the address register 220 and may receive a refresh row address REF_ADDR from the refresh control circuit 400. The row address multiplexer 240 may selectively output the row address ROW_ADDR or the refresh row address REF_ADDR as a row address RA. The row address RA output from the row address multiplexer 240 may be applied to each of the plurality of row decoders 260_1 to 260_n.

In response to refresh signals from the control logic circuit 210, the refresh control circuit 400 may sequentially increase or decrease the refresh row address REF_ADDR in a normal refresh mode.

The refresh control circuit 400 may receive a hammer address HADDR in a hammer refresh mode. Based on the hammer address HADDR, the refresh control circuit 400 may output an address of a word line(s) adjacent to an intensively accessed word line as the refresh row address REF_ADDR.

A row decoder selected by the bank control circuit 230 from among the plurality of row decoders 260_1 to 260_n may activate a word line corresponding to the row address RA output from the row address multiplexer 240. For example, the selected row decoder may apply a word line driving voltage to the word line corresponding to the row address RA.

The column address latch 250 may receive the column address COL_ADDR from the address register 220 and may temporarily store the received column address COL_ADDR. Also, for example, in a burst mode, the column address latch 250 may sequentially increase the received column address COL_ADDR. The column address latch 250 may apply the temporarily stored or sequentially increased column address COL_ADDR' to each of the plurality of column decoders 270_1 to 270_n.

A column decoder activated by the bank control circuit 230 from among the plurality of column decoders 270_1 to 270_n may activate a sense amplifier corresponding to the bank address BANK_ADDR and the column address COL_ADDR through the input/output gating circuit 290.

The input/output gating circuit 290 may include circuits which gate input/output data. Also, the input/output gating circuit 290 may include data latches for storing codewords output from the plurality of bank arrays 310_1 to 310_n and write drivers for writing data in the plurality of bank arrays 310_1 to 310_n.

According to an embodiment, the input/output gating circuit 290 may include multiplexer circuits for controlling the flow of data to be input/output through column blocks. For example, the input/output gating circuit 290 may include a plurality of first multiplexer circuits respectively corresponding to the plurality of first column blocks and at least one second multiplexer circuit respectively corresponding to the at least one second column block.

According to an embodiment, each of the at least one second multiplexer circuit may be connected to a second global input/output line connected to the corresponding second column block, and each of the plurality of first multiplexer circuits may be connected to a first global input/output line connected to the corresponding first column block, and the second global input/output line.

In this case, in the read operation of the first mode Mode 1, each of the plurality of first multiplexer circuits may output the applied output data to the connected first global input/output line, and each of the at least one second multiplexer circuit may output the applied output data to the connected second global input/output line. Also, in the write operation of the first mode Mode 1, each of the plurality of first multiplexer circuits may apply the input data to the connected first global input/output line, and each of the at least one second multiplexer circuit may apply the input data to the connected second global input/output line. Meanwhile, in the first mode Mode 1, the normal data may be input/output through the plurality of first multiplexer circuits, and the metadata may be input/output through the at least one second multiplexer circuit.

Meanwhile, in the second mode Mode 2, each of the plurality of first multiplexer circuits may receive the column address and may select a global input/output line based on the received column address. In detail, when one of the second number of column addresses is applied, each of the plurality of first multiplexer circuits may select one of global input/output lines connected to the corresponding first multiplexer circuit, based on the applied column address. According to the above description, in the read operation, each of the plurality of first multiplexer circuits may output the applied output data to the selected global input/output line. Also, in the write operation, each of the plurality of first multiplexer circuits may apply the input data to the selected global input/output line.

Meanwhile, according to an embodiment, each of the at least one second multiplexer circuit may be connected to a second global input/output line connected to the corresponding second column block; at least one of the plurality of first multiplexer circuits may be connected to a first global input/output line connected to the corresponding first column block, and the second global input/output line; each of the others of the plurality of first multiplexer circuits may be connected to a first global input/output line connected to the corresponding first column block, and a first global input/output line connected to an adjacent first column block.

In this case, in the read operation of the first mode Mode 1, each of the plurality of first multiplexer circuits may output the applied output data to the connected first global input/output line, and each of the at least one second multiplexer circuit may output the applied output data to the connected second global input/output line. Also, in the write operation of the first mode Mode 1, each of the plurality of first multiplexer circuits may apply the input data to the connected first global input/output line, and each of the at least one second multiplexer circuit may apply the input data to the connected second global input/output line.

Meanwhile, in the second mode Mode 2, each of the plurality of first multiplexer circuits may receive the column address and may select a global input/output line based on the received column address. In detail, in the second mode Mode 2, when one of the second number of column addresses is applied, each of the plurality of first multiplexer circuits may select one of global input/output lines connected to the corresponding first multiplexer circuit, based on the applied column address. According to the above description, in the read operation, each of the plurality of first multiplexer circuits may output the applied output data to the selected global input/output line. Also, in the write operation, each of the plurality of first multiplexer circuits may apply the input data to the selected global input/output line. Meanwhile, in the second mode Mode 2, the normal data may be input/output through the plurality of first multiplexer circuits, and data need not be input/output through the at least one second multiplexer circuit.

An example in which the above multiplexer circuits are included in the input/output gating circuit 290 is described, but the present disclosure is not limited thereto. For example, the above multiplexer circuits may be disposed in various regions of the memory device 200, to which the first and second global input/output lines are connected, separately from the input/output gating circuit 290.

In an embodiment, in the read operation, a codeword CW read from a bank array selected from the plurality of bank arrays 310_1 to 310_n may be sensed by a sense amplifier corresponding to the selected bank array and may be stored in the data latches of the input/output gating circuit 290. Also, ECC decoding for the codeword CW stored in the data latches may be performed by the ECC engine 350 so as to be provided to the data input/output buffer 320 as data DTA. The data input/output buffer 320 may generate a data signal DQ based on the data DTA and may provide the data signal DQ to the memory controller 100 together with a strobe signal DQS.

In an embodiment, in the write operation, the data DTA to be written in a bank array selected from the plurality of bank arrays 310_1 to 310_n may be received by the data input/output buffer 320 as the data signal DQ. The data input/output buffer 320 may convert the data signal DQ into the data DTA so as to be provided to the ECC engine 350. The ECC engine 350 may generate parity bits (or parity data) based on the data DTA and may provide the input/output gating circuit 290 with the codeword CW including the data DTA and the parity bits. The input/output gating circuit 290 may write the codeword CW in the selected bank array.

In the write operation, the data input/output buffer 320 may convert the data signal DQ into the data DTA so as to be provided to the ECC engine 350. In the read operation, the data input/output buffer 320 may convert the data DTA provided from the ECC engine 350 into the data signal DQ.

In the write operation, the ECC engine 350 may perform ECC encoding for the data DTA. In the read operation, the ECC engine 350 may perform ECC decoding for the codeword CW. According to an embodiment, the parity data which the ECC engine 350 generates or uses may be data different from the above metadata and may be stored in a third region of the bank array, which is different from the first region RG1 and the second region RG2 described above.

The control logic circuit 210 may control the operation of the memory device 200. For example, the control logic circuit 210 may generate control signals such that the memory device 200 performs the write operation, the read operation, the normal refresh operation, and the hammer refresh operation. The control logic circuit 210 may include a command decoder 211 which decodes a command CMD received from the memory controller 100 and a mode register set (MRS) 212 for setting an operation mode of the memory device 200.

The command decoder 211 may decode the command CMD to generate internal command signals such as an internal active signal IACT, an internal precharge signal IPRE, an internal read signal IRD, and an internal write signal IWR. Also, the command decoder 211 may generate control signals corresponding to the command CMD by decoding a chip select signal, a command/address signal, etc.

The mode register set 212 may set the operation mode of the memory device 200. According to an embodiment, the mode register set 212 may include a mode register for setting the operation mode of the memory device 200 to the first mode Mode 1 or the second mode Mode 2. For example, when a first value is set in the mode register, the memory device 200 may operate in the first mode Mode 1. Also, when a second value different from the first value is set in the mode register, the memory device 200 may operate in the second mode Mode 2.

According to an embodiment of the present disclosure, the first region RG1 and the second region RG2 may be connected in common to a plurality of word lines. Accordingly, when one word line corresponding to the row address from among the plurality of word lines is activated, a region corresponding to the activated word line may be activated together in the first region RG1 and the second region RG2. In this case, when the column address is applied, column selection lines of the first region RG1 corresponding to the applied column address and a column selection line(s) of the second region RG2 corresponding to the applied column address may be simultaneously activated.

Accordingly, when the memory device 200 operates in the first mode Mode 1, the normal data and the metadata corresponding to the normal data may be input together to the first region RG1 and the second region RG2 or may be output together from the first region RG1 and the second region RG2. In this case, the applied column address may be one of the first number of column addresses.

Also, when the memory device 200 operates in the second mode Mode 2, the normal data may be input together to the first region RG1 and the second region RG2 or may be output together from the first region RG1 and the second region RG2. In this case, the applied column address may be one of the second number of column addresses.

According to the above embodiment of the present disclosure, there is provided the memory device 200 capable of operating in the first mode Mode 1 in which the metadata are provided or the second mode Mode 2 in which the metadata are not provided, without the reduction of bus efficiency or the increase in power consumption. Accordingly, it may be possible to provide the metadata efficiently.

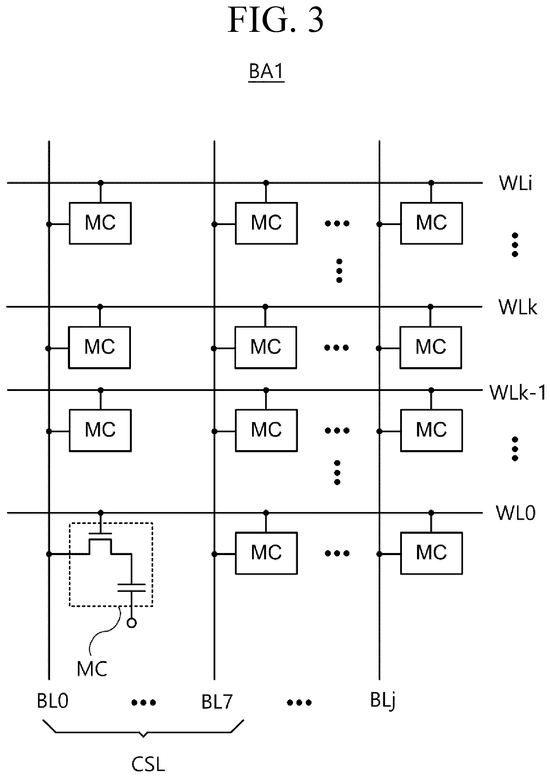

FIG. 3 is a diagram illustrating an example of a bank array according to an embodiment of the present disclosure. A bank array BA1 of FIG. 3 may correspond, for example, to the bank array BA1 of FIGS. 1 and 2, but the present disclosure is not limited thereto.

Referring to FIG. 3, the bank array BA1 may include a plurality of word lines WL0 to WLi, a plurality of bit lines BL0 to BLj, and a plurality of memory cells MC. In an embodiment, the plurality of memory cells MC may be disposed at intersections of the word lines WL0 to WLi and the bit lines BL0 to BLj.

In an embodiment, each memory cell MC may be a DRAM cell. For example, each memory cell MC may include a cell transistor connected to a word line and a bit line and a cell capacitor connected to the cell transistor.

One column selection line CSL may be electrically connected to a plurality of bit lines. For example, one column selection line CSL may be electrically connected to 8 bit lines BL0 to BL7. In this case, through one word line and one column selection line CSL, 8-bit data may be read from the memory cells MC or may be written in the memory cells MC. However, this is provided as an example, and one column selection line CSL may be implemented to be electrically connected to bit lines, the number of which is variously determined to be different from 8.

According to an embodiment, a word line extending in the row direction may be referred to as a "row" of the bank array BA1. Also, the column selection line CSL extending in the column direction may be referred to as a "column" of the bank array BA1.

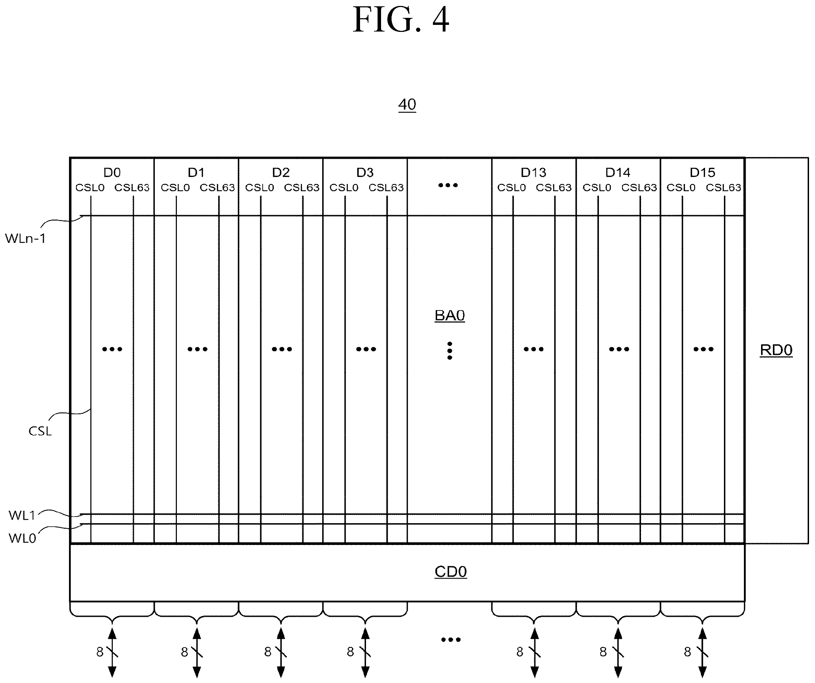

FIG. 4 is a diagram for describing a bank structure of a typical memory device not supporting metadata. Referring to FIG. 4, a bank 40 may include a bank array BA0, a row decoder RD0 corresponding to the bank array BA0, and a column decoder CD0 corresponding to the bank array BA0. Also, in FIG. 4, "WL" may indicate a word line, and "CSL" may indicate a column selection line.

In the example of FIG. 4, it is assumed that the bank array BA0 has a page size of 1 KB (kilobyte), a prefetch size is 128 bits, and one column selection line CSL corresponds to 8 bit lines. Also, it is assumed that only normal data are stored in the bank array BA0.

In this case, as illustrated, the bank array BA0 may include 16 column blocks D0 to D15, and each of the column blocks D0 to D15 may include 64 column selection lines CSLO to CSL63. Accordingly, the bank 40 may operate based on 64 column addresses respectively corresponding to the 64 column selection lines CSLO to CSL63.

The row decoder RD0 may activate a word line corresponding to the applied row address, and the column decoder CD0 may activate a column selection line corresponding to the applied column address.

For example, when the column address corresponding to one column selection line CSLO is applied in a state where the first word line WL0 is activated, the column decoder CD0 activates the column selection line CSLO in each of the 16 column blocks D0 to D15. In this case, because each of the activated column selection lines CSLO corresponds to 8 bit lines, normal data of 128 bits being the prefetch size may be input or output through global input/output lines respectively corresponding to column blocks. The above description will also be applied to the remaining column addresses.

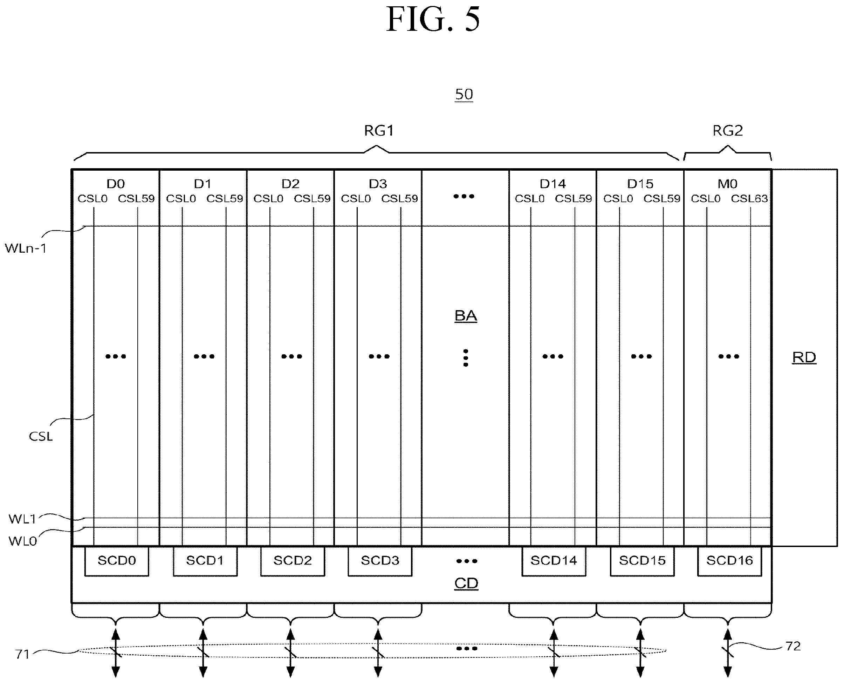

FIG. 5 is a diagram illustrating a bank structure of a memory device according to an embodiment of the present disclosure. A bank 50 of FIG. 5 may be one of the banks included in the memory device 200 of FIG. 1 or 2, but the present disclosure is not limited thereto.

According to an embodiment of the present disclosure, the memory device 200 may provide the normal data and the metadata corresponding to the normal data at a ratio of 16:1. However, an embodiment is not limited thereto. For example, the memory device 200 may provide the normal data and the metadata corresponding to the normal data at any other ratio such as 8:1.

A bank structure capable of providing the normal data and the metadata corresponding to the normal data at a ratio of 16:1 is illustrated in FIG. 5 as an example. For the convenience of comparison with the bank 40 described with reference to FIG. 4, it is assumed that a bank array BA of FIG. 5 has a page size is 1 KB (kilobyte), a prefetch size is 128 bits, and one column selection line CSL corresponds to 8 bit lines.

Referring to FIG. 5, a bank 50 may include the bank array BA, a row decoder RD corresponding to the bank array BA, and a column decoder CD corresponding to the bank array BA. Also, in FIG. 5, "WL" may indicate a word line, and "CSL" may indicate a column selection line.

In this case, according to an embodiment, the bank array BA may include 16 first column blocks D0 to D15 and one second column block M0. The first column blocks D0 to D15 may correspond to the first region RG1 described above, and the second column block M0 may correspond to the second region RG2 described above.

In this case, each of the 16 first column blocks D0 to D15 may include 60 column selection lines CSLO to CSL59, and the second column block M0 may include 64 column selection lines CSLO to CSL63.

In detail, comparing the bank array BA and the bank array BA0, the bank array BA may further include the second column block M0 including 64 column selection lines. In this case, because the page size of the bank array BA is identical to the page size of the bank array BA0, each of the first column blocks D0 to D15 may include only 60 column selection lines CSLO to CSL59, not 64 column selection lines.

The row decoder RD may activate a word line corresponding to the applied row address, and the column decoder CD may activate a column selection line corresponding to the applied column address. In this case, according to an embodiment, the column decoder CD may include 17 sub-column decoders SCDO to SCD16 respectively corresponding to 17 column blocks D0 to D15 and M0, and an operation of each of the column blocks D0 to D15 and M0 may be controlled by the corresponding sub-column decoder. However, the present disclosure is not limited thereto.

Meanwhile, the bank 50 supports the operation of the first mode Mode 1 described above. In the first mode Mode 1, the bank 50 may operate based on 60 column addresses respectively corresponding to the 60 column selection lines CSLO to CSL59.

For example, when a column address corresponding to one column selection line (e.g., CSLO) is applied in a state where the first word line WL0 is activated, the column decoder CD may activate the column selection line CSLO in each of the 17 column blocks D0 to D15 and M0. In this case, because each of the activated column selection lines CSLO corresponds to 8 bit lines, 128-bit normal data may be input or output through global input/output lines 71 corresponding to 16 first column blocks D0 to D15 included in the first region RG1. At the same time, 8-bit metadata may be input or output through global input/output lines 72 corresponding to the second column block M0 included in the second region RG2. The above description will also be applied to the remaining 59 column addresses.

According to the above description, like the example illustrated in FIG. 5, the memory device 200 including the bank 50 can operate in the first mode Mode 1 and thus may input or output the 128-bit normal data being the prefetch size and the additional 8-bit metadata through the first region RG1 and the second region RG2. In this case, the number of column addresses capable of being used may be 60.

Also, the bank 50 supports the operation of the second mode Mode 2 described above. In the second mode Mode 2, the bank 50 may operate based on 64 column addresses.

To support the 64 column addresses, 64 column selection lines corresponding to the 64 column addresses may be required. However, because each of the first column blocks D0 to D15 includes only the 60 column selection lines CSLO to CSL59, only 60 column addresses among the 64 column addresses may be mapped (or allocated) to the column selection lines CSLO to CSL59 of each of the first column blocks D0 to D15.

According to embodiments of the present disclosure, to map the remaining 4 column addresses not mapped to the column selection lines CSLO to CSL59 of the first column block in the second mode Mode 2, the column selection lines CSLO to CSL63 included in the second column block M0 may be used. In this case, the 4 column addresses not mapped to the 60 column selection lines CSLO to CSL59 of the first column block from among the 64 column addresses may differ for every first column block.

In detail, according to an embodiment, the 4 column addresses not mapped to the 60 column selection lines CSLO to CSL59 of the first column block from among the 64 column addresses may be mapped to 4 column selection lines included in the second column block M0. In this case, 64 column selection lines corresponding to 64 column addresses may include 60 column selection lines CSLO to CSL59 of the first column block and 4 column selection lines of the second column block M0.

For example, the 64 column addresses may be mapped to the 60 column selection lines CSLO to CSL59 of the first column block D0 and the 4 column selection lines (e.g., CSLO to CSL3) included in the second column block M0. Also, the 64 column addresses may be mapped to the 60 column selection lines CSLO to CSL59 included in the first column block D1 and 4 other column selection lines (e.g., CSL4 to CSL7) included in the second column block M0. In addition, the 64 column addresses may be mapped to the 60 column selection lines CSLO to CSL59 included in the first column block D2 and 4 other column selection lines (e.g., CSL8 to CSL11) included in the second column block M0. As in the above description, the 64 column addresses may be allocated to column selection lines included in the first column blocks D3 to D15 and the second column block M0.

In this case, when one column address among the 64 column addresses is applied in a state where the first word line WL0 is activated, one of the first column blocks D0 to D15 need not include a column selection line corresponding to the applied column address. Accordingly, the column decoder CD may activate a column selection line corresponding to the applied column address in each of the remaining first column blocks other than some of the first column blocks D0 to D15 and the second column block M0. In this case, the some of the first column blocks D0 to D15 may include a first column block not including a column selection line corresponding to the applied column address.

Accordingly, because each of the activated column selection lines corresponds to 8 bit lines, 120-bit normal data may be input or output through the global input/output lines 71 respectively corresponding to the remaining 15 first column blocks other than one first column block not including a column selection line corresponding to the applied column address from among the 16 first column blocks D0 to D15 included in the first region RG1. At the same time, 8-bit normal data may be input or output through the global input/output line 72 corresponding to the second column block M0 included in the second region RG2.

According to the above description, like the example illustrated in FIG. 5, the memory device 200 including the bank 50 can operate in the second mode Mode 2 and thus may input or output the 128-bit normal data being the prefetch size through the first region RG1 and the second region RG2. In this case, the number of column addresses capable of being used may be 64.

According to the above embodiment of the present disclosure, the memory device 200 supporting the first mode Mode 1 and the second mode Mode 2 may be provided without the reduction of bus efficiency or the increase in page size. Accordingly, it may be possible to provide the metadata efficiently.

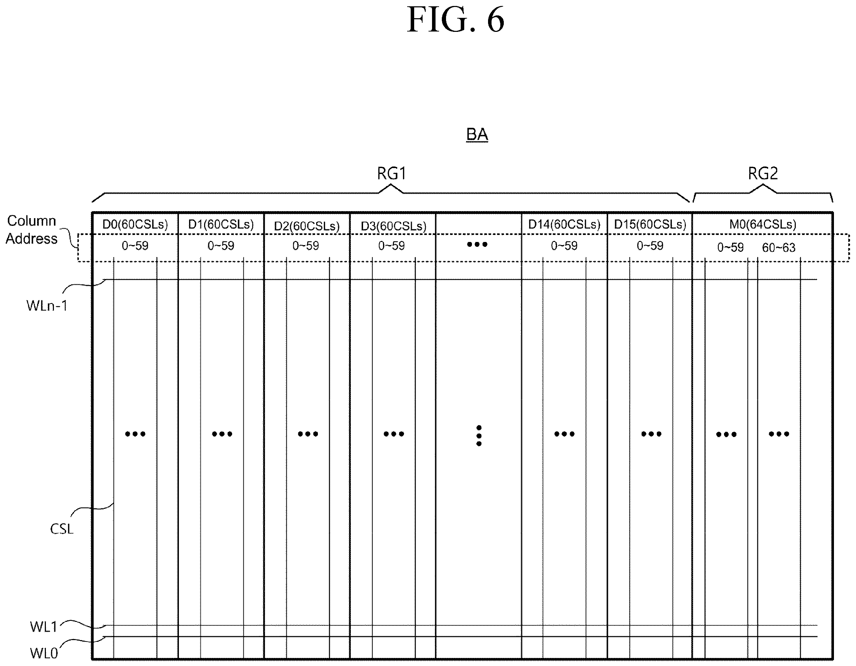

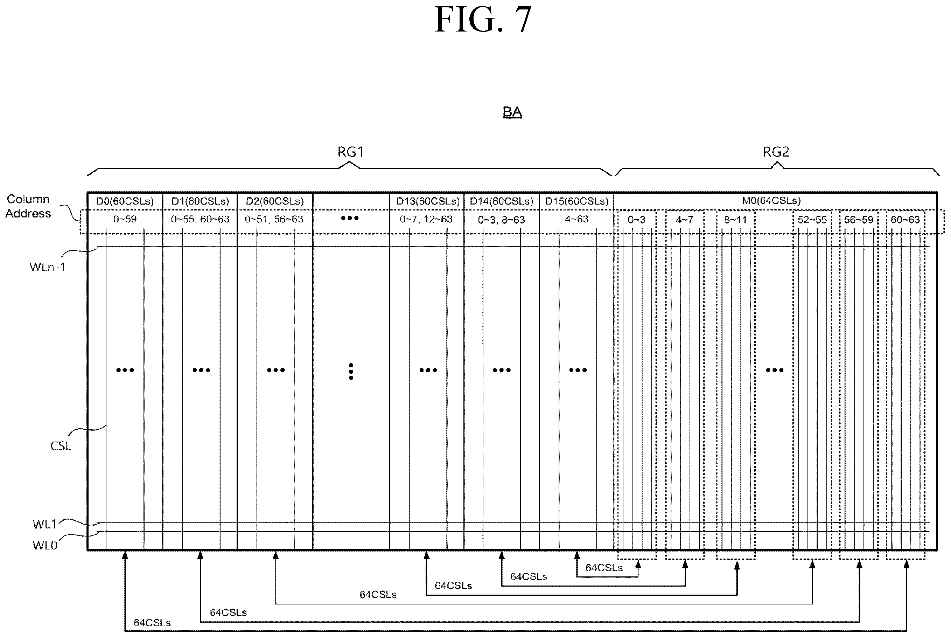

FIGS. 6 and 7 are diagrams for describing a mapping relationship between column selection lines and column addresses according to an embodiment of the present disclosure. The bank array BA illustrated in FIGS. 6 and 7 may be an example of the bank array included in the memory device 200 of FIGS. 1 and 2 or an example of the bank array included in the bank 50 of FIG. 5, but the present disclosure is not limited thereto.

Meanwhile, the bank array BA of FIG. 6 and the bank array BA of FIG. 7 may be identical in configuration. Referring to FIGS. 6 and 7, the bank array BA may include 16 first column blocks D0 to D15 and one second column block M0. In this case, each of the first column blocks D0 to D15 may include 60 column selection lines, and the second column block M0 may include 64 column selection lines.

FIG. 6 shows an example of the mapping relationship between column selection lines included in the bank array BA and column addresses when the memory device 200 operates in the first mode Mode 1.

Referring to FIG. 6, the 60 column selection lines included in each of the first column blocks D0 to D15 may be respectively mapped to the 60 column addresses from 0 to 59. Also, 60 column selection lines among 64 column selection lines included in the second column block M0 may be respectively mapped to the 60 column addresses from 0 to 59.

In this case, when one column address among the 60 column addresses from 0 to 59 is applied, the column decoder CD may select a column selection line corresponding to the applied column address in each of the first column blocks D0 to D15 and the second column block M0 and may activate the selected column selection lines.

FIG. 7 shows an example of the mapping relationship between column selection lines included in the bank array BA and column addresses when the memory device 200 operates in the second mode Mode 2.

Referring to FIG. 7, 60 column selection lines included in one first column block and 4 column selection lines included in a second column block may constitute 64 column addresses.

For example, 64 column addresses 0 to 63 may be mapped to the 60 column selection lines of the first column block D0 and the 4 column selection lines included in the second column block M0. Also, the 64 column addresses may be mapped to the 60 column selection lines included in the first column block D1 and 4 other column selection lines included in the second column block M0. In addition, the 64 column addresses may be allocated to the 60 column selection lines included in the first column block D2 and 4 other column selection lines included in the second column block M0. As in the above description, the 64 column addresses may be allocated to column selection lines included in each of the first column blocks D3 to D15 and the second column block M0.

In this case, 4 column addresses not mapped to the 60 column selection lines may differ for every first column block. For example, the 60 selection lines included in the first column block D0 may be mapped to the 60 column addresses from 0 to 59. Accordingly, the 4 column addresses from 60 to 63 are not mapped to the column selection lines included in the first column block D0. Also, the 60 column selection lines included in the first column block D1 may be mapped to the 60 column addresses from 0 to 55 and from 60 to 63. Accordingly, the 4 column addresses from 56 to 59 are not mapped to the column selection lines included in the first column block D1. Also, the 60 column selection lines included in the first column block D2 may be mapped to the 60 column addresses from 0 to 51 and from 56 to 63. Accordingly, the 4 column addresses from 52 to 55 are not mapped to the column selection lines included in the first column block D2.

According to an embodiment of the present disclosure, 4 column addresses not mapped to column selection lines of the first column block may be mapped to column selection lines included in the second column block M0. For example, the 4 column addresses from 60 to 63 may be mapped to 4 column selection lines of the second column block M0 paired with the first column block D0. Also, the 4 column addresses from 56 to 59 may be mapped to 4 column selection lines of the second column block M0 paired with the first column block D1. In addition, the 4 column addresses from 52 to 55 may be mapped to 4 column selection lines of the second column block M0 paired with the first column block D2.

As in the above description, the 64 column addresses may be allocated to column selection lines included in each of the first column blocks D0 to D15 and the second column block M0.

According to the above mapping relationship, when one column address among the 64 column addresses is applied in the second mode Mode 2, one of the first column blocks D0 to D15 does not include a column selection line corresponding to the applied column address. Accordingly, the column decoder CD may select a column selection line corresponding to the applied column address in each of the remaining first column blocks other than the one of the first column blocks D0 to D15 and the second column block M0 and may activate the selected column selection line.

For example, the first column block D0 does not include column selection lines corresponding to column addresses from 60 to 63. Accordingly, when one of the column addresses from 60 to 63 is applied, the column decoder CD may select a column selection line corresponding to the applied column address in each of the remaining first column blocks D1 to D15 other than the first column block D0 and the second column block M0 and may activate the selected column selection lines.

Also, for example, the first column block D13 does not include column selection lines corresponding to column addresses from 8 to 11. Accordingly, when one of the column addresses from 8 to 11 is applied, the column decoder CD may select a column selection line corresponding to the applied column address in each of the remaining first column blocks D0 to D12, D14, and D15 other than the first column block D13 and the second column block M0 and may activate the selected column selection lines.

Even when one of the remaining column addresses is applied, the memory device 200 may operate in the above manner.

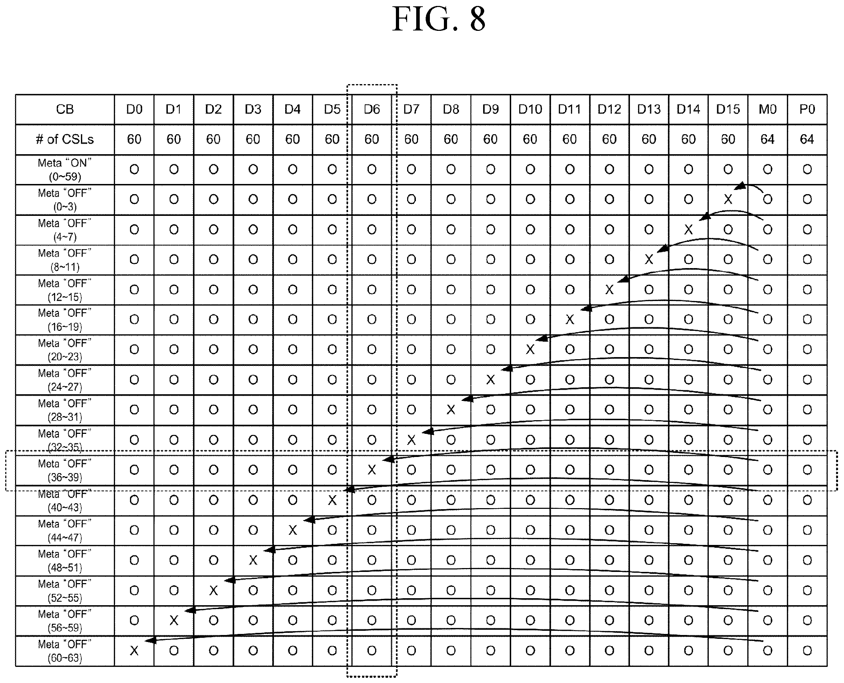

FIG. 8 is a table illustrating a mapping relationship between column selection lines and column addresses according to an embodiment of the present disclosure. The table of FIG. 8 shows a summarized column address mapping relationship for each mode of the bank array BA described with reference to FIGS. 6 and 7.

In FIG. 8, "CB" indicates a column block, "# of CSLs" indicates the number of column selection lines, Meta "ON" indicates the first mode Mode 1, and Meta "OFF" indicates the second mode Mode 2. Also, numbers in parentheses below Meta "ON" and Meta "OFF" indicate column addresses.

Referring to FIG. 8, in the case of the first mode Mode 1, the 60 column selection lines included in each of the first column blocks D0 to D15 may be respectively mapped to the 60 column addresses from 0 to 59. Also, 60 column selection lines among 64 column selection lines included in the second column block M0 may be respectively mapped to the 60 column addresses from 0 to 59.

Accordingly, in the first mode Mode 1, when one of the column addresses from 0 to 59 is applied, a column selection line corresponding to the applied column address may be activated together in each of the first column blocks D0 to D15 and the second column block

M0.

Meanwhile, in the second mode Mode 2, 60 column addresses among the 64 column addresses from 0 to 63 may be mapped to each of the first column blocks D0 to D15. In this case, 4 column addresses not mapped may differ for every first column block and may be mapped by using column selection lines of the second column block M0.

In this case, in the second mode Mode 2, when one of the 64 column addresses is applied, the column decoder CD may activate a column selection line corresponding to the applied column address in each of the remaining first column blocks other than one of the first column blocks D0 to D15 and the second column block M0. In this case, the one of the first column blocks D0 to D15 may include a first column block not including the column selection line corresponding to the applied column address.

For example, the 60 column addresses from 0 to 35 and from 40 to 63 may be mapped to 60 column selection lines included in the first column block D6. In this case, 4 column addresses from 36 to 39 not mapped to the first column block D6 may be mapped to 4 column selection lines included in the second column block M0. In this case, when one of the column addresses from 36 to 39 is applied, 16 column selection lines corresponding to the applied column address may be activated in the 16 column blocks D0 to D5, D7 to D15, and M0 other than the first column block D6.

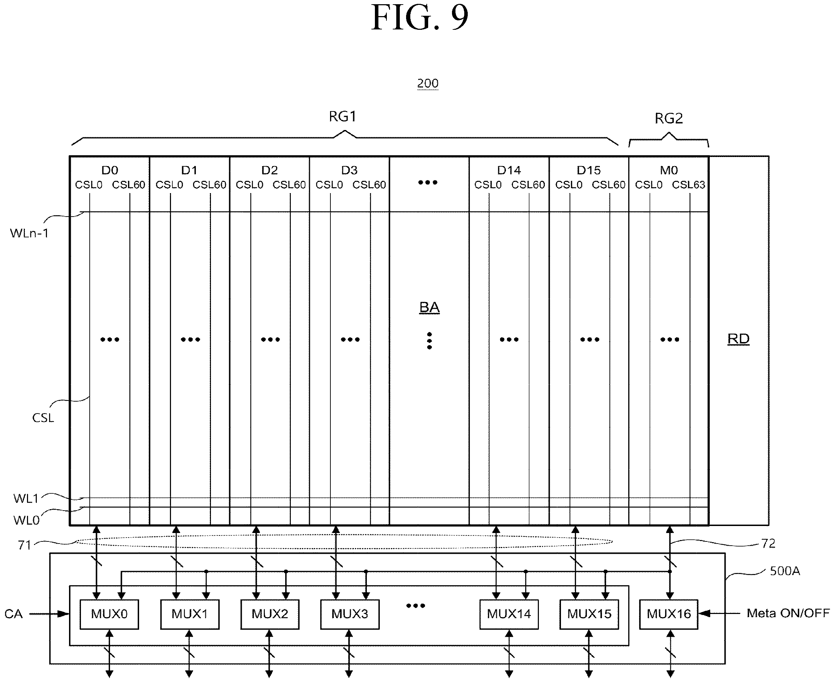

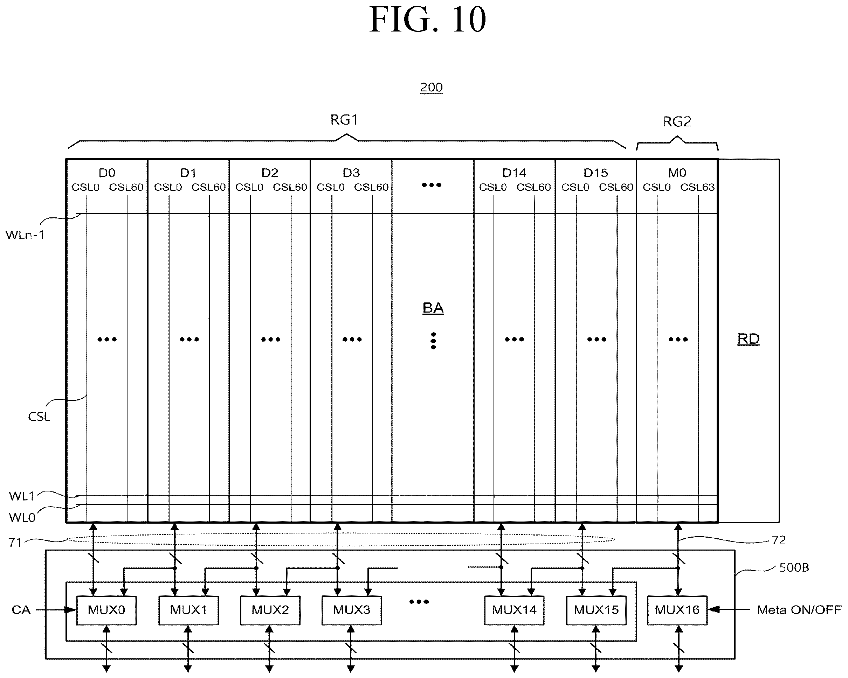

Meanwhile, in FIG. 8, a column block P0 may be a column block corresponding to a region, in which parity data are stored, from among regions of the bank array BA. The column block P0 may be included in a separate third region, not included in any of the first region RG1 including the first column blocks D0 to D15 and the second region RG2 including the second column block M0. For example, parity data which are generated or used by the ECC engine 350 may be stored in the column block P0. According to an embodiment, the column block P0 in which parity data are stored may also be additionally disposed in the bank array BA described with reference to FIGS. 1, 2, 5, and 6 and the bank array BA to be described with reference to FIGS. 9 and 10.

Meanwhile, of course, a structure of a bank array according to embodiments of the present disclosure is not limited to that illustrated in FIGS. 6 to 8. For example, the number of first column blocks included in the first region RG1, the number of second column blocks included in the second region RG2, and the number of column selection lines included in each column block may be variously changed depending on a page size of a bank array, a prefetch size of normal data required, the number of bit lines per column selection line, and a ratio at which normal data and metadata are provided. Also, the mapping relationship between column selection lines and column addresses described with reference to FIGS. 6 to 8 is provided as an example, and an embodiment is not limited thereto. A mapping relationship which allows the operations in the first mode Mode 1 and the second mode Mode 2 to be performed through the same single bank array structure including the first region RG1 and the second region RG2 may be variously defined to be different from the above mapping relationship.

Meanwhile, as described above, the memory device 200 may include multiplexer circuits for controlling the flow of data to be input/output through column blocks.

Referring to the example of FIG. 5, when the memory device 200 operates in the first mode Mode 1, normal data and metadata may be input/output through the global input/output lines 71 corresponding to the 16 first column blocks D0 to D15 and the global input/output lines 72 corresponding to the second column block M0.

In contrast, when the memory device 200 operates in the second mode Mode 2, normal data are not input/output through one global input/output line, among the global input/output lines 71, corresponding to one of the 16 first column blocks D0 to D15, and normal data input/output through the global input/output lines 72 corresponding to the second column block M0 replaces the normal data not input/output through the one global input/output line. Also, the normal data may be input/output through the global input/output lines 71 connected to the 15 first column blocks other than the one of the 16 first column blocks D0 to D15.

For the above operation, according to an embodiment of the present disclosure, the memory device 200 may include multiplexer circuits capable of controlling the flow of data input/output to/from each of the first column blocks D0 to D15 and the second column block M0.

FIG. 9 is a diagram for describing a configuration and an operation of multiplexer circuits according to embodiments of the present disclosure.

Referring to FIG. 9, the memory device 200 may include a plurality of multiplexer circuits 500A for controlling the flow of data input/output to/from the bank array BA. In this case, the plurality of multiplexer circuits 500A may include a plurality of first multiplexer circuits MUX0 to MUX15 respectively corresponding to the plurality of first column blocks D0 to D15 and a second multiplexer circuit MUX16 corresponding to the second column block M0.

According to an embodiment, the second multiplexer circuit MUX16 may be connected to the second global input/output line 72 connected to the second column block M0. Also, each of the plurality of first multiplexer circuits MUX0 to MUX15 may be connected to the first global input/output line 71 connected to the corresponding first column block and the second global input/output line 72.

For example, when a setting value for setting the operation mode of the memory device 200 to the first mode Mode 1 or the second mode Mode 2 is a value of "Meta ON" corresponding to the first mode Mode 1, each of the plurality of first multiplexer circuits MUX0 to MUX15 may select the first global input/output line 71 among the connected first and second global input/output lines 71 and 72 and may input/output data through the selected first global input/output line 71. Also, the second multiplexer circuit MUX16 may input/output data through the connected second global input/output line 72.

That is, in the read operation of the first mode Mode 1, each of the plurality of first multiplexer circuits MUX0 to MUX15 may output the applied output data to the first global input/output line 71, and the second multiplexer circuit MUX16 may output the applied output data to the second global input/output line 72. Also, in the write operation of the first mode Mode 1, each of the plurality of first multiplexer circuits MUX0 to MUX15 may apply the input data to the first global input/output line 71, and the second multiplexer circuit MUX16 may apply the input data to the second global input/output line 72.

Meanwhile, when the setting value of the mode register is a value of "Meta OFF" corresponding to the second mode Mode 2, each of the plurality of first multiplexer circuits MUX0 to MUX15 may select one of the connected first and second global input/output lines 71 and 72, based on the applied column address CA and may input/output data through the selected global input/output line. Also, the second multiplexer circuit MUX16 need not input/output data through the connected second global input/output line 72.

In detail, in the second mode Mode 2, each of the plurality of first multiplexer circuits MUX0 to MUX15 may select the second global input/output line 72 when one of 4 column addresses not mapped to the corresponding first column block is applied and may select the first global input/output line 71 when one of 60 column addresses mapped to the corresponding first column block is applied.

According to the above description, in the read operation of the second mode Mode 2, each of the plurality of first multiplexer circuits MUX0 to MUX15 may output the applied output data to the selected global input/output line. Also, in the write operation of the second mode Mode 2, each of the plurality of first multiplexer circuits MUX0 to MUX15 may apply the input data to the selected global input/output line.

In an embodiment, in the read operation of the second mode Mode 2, when a column address not mapped to the first column block D6 is applied, the column decoder CD may select a column selection line corresponding to the applied column address in each of the 15 first column blocks D0 to D5 and D7 to D15 other than the first column block D6 and the second column block M0. According to the above description, the output data may be applied to the 15 first global input/output lines 71 respectively connected to the 15 first column blocks D0 to D5 and D7 to D15 and the second global input/output line 72 connected to the second column block M0.

In this case, the first multiplexer circuit MUX6 corresponding to the first column block D6 from among the plurality of first multiplexer circuits MUX0 to MUX15 may select the second global input/output line 72 among the connected first and second global input/output lines 71 and 72, and each of the remaining first multiplexer circuits MUX0 to MUX5 and MUX7 to MUX15 may select the first global input/output line 71 connected to the first column block from among the connected first and second global input/output lines 71 and 72. According to the above description, the output data corresponding to the 15 first column blocks D0 to D5 and D7 to D15 and the second column block M0 may be output through the 16 first multiplexer circuits MUX0 to MUX15.

FIG. 10 is a diagram for describing a configuration and an operation of multiplexer circuits according to embodiments of the present disclosure.

Referring to FIG. 10, the memory device 200 may include a plurality of multiplexer circuits 500B for controlling the flow of data input/output to/from the bank array BA. In this case, the plurality of multiplexer circuits 500B may include the plurality of first multiplexer circuits MUX0 to MUX15 respectively corresponding to the plurality of first column blocks D0 to D15 and the second multiplexer circuit MUX16 corresponding to the second column block M0.

According to an embodiment, the second multiplexer circuit MUX16 may be connected to the second global input/output line 72 connected to the second column block M0. Also, the first multiplexer circuit MUX15 adjacent to the second multiplexer circuit MUX16 from among the plurality of first multiplexer circuits MUX0 to MUX15 may be connected to the first global input/output line 71 connected to the corresponding first column block D15 and the second global input/output line 72. Also, each of the others MUX0 to MUX14 of the plurality of first multiplexer circuits MUX0 to MUX15 may be connected to the first global input/output line 71 connected to the corresponding first column block and the first global input/output line 71 connected to the adjacent first column block.

For example, when a setting value of the mode register for setting the operation mode of the memory device 200 to the first mode Mode 1 or the second mode Mode 2 is a value of "Meta ON" corresponding to the first mode Mode 1, the second multiplexer circuit MUX16 may input/output data through the connected second global input/output line 72. Also, the first multiplexer circuit MUX15 may select the first global input/output line 71 among the connected first and second global input/output lines 71 and 72 and may input/output data through the selected first global input/output line 71. Also, each of the first multiplexer circuits MUX0 to MUX14 may select the first global input/output line 71 connected to the corresponding first column block from among the connected first global input/output lines 71 and may input/output data through the selected first global input/output line 71.

In this case, in the read operation of the first mode Mode 1, each of the plurality of first multiplexer circuits MUX0 to MUX15 may output the applied output data to the first global input/output line 71 connected to the corresponding first column block, and the second multiplexer circuit MUX16 may output the applied output data to the second global input/output line 72. Also, in the write operation of the first mode Mode 1, each of the plurality of first multiplexer circuits MUX0 to MUX15 may apply the input data to the first global input/output line 71 connected to the corresponding first column block, and the second multiplexer circuit MUX16 may apply the input data to the second global input/output line 72.

Meanwhile, when the setting value of the mode register is a value of "Meta OFF" corresponding to the second mode Mode 2, each of the plurality of first multiplexer circuits MUX0 to MUX15 may select one of the connected global input/output lines based on the applied column address CA and may input/output data through the selected global input/output line.

In detail, in the second mode Mode 2, each of the first multiplexer circuits MUX0 to MUX14 may select one of the first global input/output line 71 connected to the corresponding first column block and the first global input/output line 71 connected to the adjacent first column block based on the applied column address CA and may input/output data through the selected global input/output line. Also, the first multiplexer circuit MUX15 may select one of the first global input/output line 71 connected to the corresponding first column block D15 and the second global input/output line 72 based on the applied column address CA and may input/output data through the selected global input/output line. Meanwhile, the second multiplexer circuit MUX16 need not input/output data through the connected second global input/output line 72.

According to an embodiment, in the second mode Mode 2, a first multiplexer circuit (hereinafter referred to "A") corresponding to a first column block, to which the applied column address CA is not mapped, from among the plurality of first multiplexer circuits MUX0 to MUX15 may select a global input/output line connected to the adjacent column block from among the connected global input/output lines. In this case, each of first multiplexer circuits (hereinafter referred to as "B") between the "A" and the second multiplexer circuit MUX16 may also select a global input/output line connected to the adjacent column block from among the connected global input/output lines. Meanwhile, each of the remaining first multiplexer circuits among the plurality of first multiplexer circuits MUX0 to MUX15 other than the "A" and the "B" may select a first global input/output line connected to the corresponding first column block from among the connected global input/output lines.

For example, in the second mode Mode 2, when a column address not mapped to column selection lines included in the first column block D3 from among the 64 column addresses is applied, the first multiplexer circuit MUX3 corresponding to the first column block D3 may select a first global input/output line connected to the adjacent column block D4 from among the connected first global input/output lines. In this case, each of the first multiplexer circuits MUX4 to MUX15 between the first multiplexer circuit MUX3 and the second multiplexer circuit MUX16 may also select a global input/output line connected to the adjacent column block from among the connected global input/output lines. For example, the first multiplexer circuit MUX4 may select the first global input/output line connected to the first column block D5, the first multiplexer circuit MUX5 may select the first global input/output line connected to the first column block D6, and the first multiplexer circuit MUX6 may select the first global input/output line connected to the first column block D7. Likewise, each of the first multiplexer circuits MUX7 to MUX14 may also select the first global input/output line connected to the adjacent first column block. The first multiplexer circuit MUX15 may select the second global input/output line connected to the adjacent second column block M0. Meanwhile, each of the first multiplexer circuits MUX0 to MUX2 may select a first global input/output line connected to the corresponding first column block from among the connected global input/output lines. For example, the first multiplexer circuit MUX0 may select the first global input/output line connected to the first column block D0, the first multiplexer circuit MUX1 may select the first global input/output line connected to the first column block D1, and the first multiplexer circuit MUX2 may select the first global input/output line connected to the first column block D2.

In an embodiment, in the read operation of the second mode Mode 2, when a column address not mapped to the first column block D6 is applied, the column decoder CD may select a column selection line corresponding to the applied column address in each of the 15 first column blocks D0 to D5 and D7 to D15 other than the first column block D6 and the second column block M0. According to the above description, the output data may be applied to the 15 first global input/output lines 71 respectively connected to the 15 first column blocks D0 to D5 and D7 to D15 and the second global input/output line 72 connected to the second column block M0.

In this case, the first multiplexer circuit MUX6 corresponding to the first column block D6 from among the plurality of first multiplexer circuits MUX0 to MUX15 may select the first global input/output line connected to the adjacent column block D7. In this case, each of the first multiplexer circuits MUX7 to MUX15 between the first multiplexer circuit MUX6 and the second multiplexer circuit MUX16 may also select a global input/output line connected to the adjacent column block from among the connected global input/output lines. For example, the first multiplexer circuit MUX7 may select the first global input/output line connected to the first column block D8, the first multiplexer circuit MUX8 may select the first global input/output line connected to the first column block D9, and the first multiplexer circuit MUX9 may select the first global input/output line connected to the first column block D10. Likewise, each of the first multiplexer circuits MUX10 to MUX14 may also select the first global input/output line connected to the adjacent first column block. In this case, the first multiplexer circuit MUX15 may select the second global input/output line connected to the adjacent second column block M0. Meanwhile, each of the first multiplexer circuits MUX0 to MUX5 may select a first global input/output line connected to the corresponding first column block from among the connected global input/output lines. For example, the first multiplexer circuit MUX0 may select the first global input/output line connected to the first column block D0, the first multiplexer circuit MUX1 may select the first global input/output line connected to the first column block D1, and the first multiplexer circuit MUX2 may select the first global input/output line connected to the first column block D2. The above description is also applied to the first multiplexer circuits MUX3 to MUX5.

According to the above description, the output data corresponding to the 15 first column blocks D0 to D5 and D7 to D15 and the second column block M0 may be output through the 16 first multiplexer circuits MUX0 to MUX15.

Meanwhile, as described above, according to an embodiment, each of the first column blocks D0 to D15 includes 60 column selection lines. In this case, to support 64 column addresses in the second mode Mode 2, 4 column selection lines may be additionally required for every first column block, and the additionally required column selection lines may be replaced with column selection lines of the second column block M0.

In this case, according to the plurality of multiplexer circuits 500A of FIG. 9, the second global input/output line 72 connected to the second column block M0 may be directly connected to the plurality of first multiplexer circuits MUX0 to MUX15. Accordingly, in the second mode Mode 2, it may be understood that 4 column selection lines required in each of the first column blocks D0 to D15 are directly provided from the second column block M0 to the corresponding first column block. In contrast, according to the plurality of multiplexer circuits 500B of FIG. 10, a global input/output line connected to an adjacent column block may be connected to each of the plurality of first multiplexer circuits MUX0 to MUX15. Accordingly, in the second mode Mode 2, it may be understood that 4 column selection lines required in each of the first column blocks D0 to D15 are shifted between the second column block M0 and the corresponding first column block so as to be provided from the second column block M0.

Accordingly, the structure and operation manner of the plurality of multiplexer circuits 500A of FIG. 9 may be called a "direct manner" or a "global manner", and the structure and operation manner of the plurality of multiplexer circuits 500B of FIG. 10 may be called a "shifting manner". However, the present disclosure is not limited thereto.

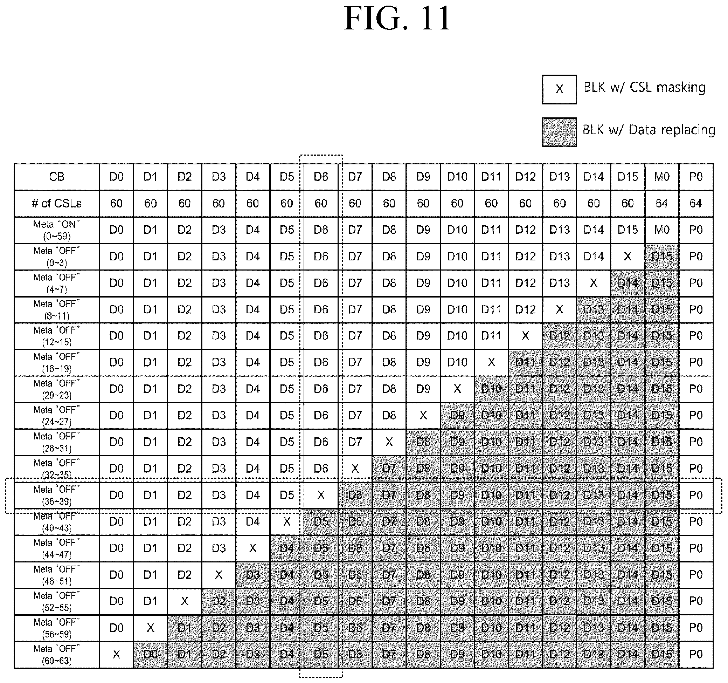

FIG. 11 is a diagram for describing a mapping relationship between column selection lines and column addresses according to an embodiment of the present disclosure. In FIG. 11, the case where the memory device 200 includes the plurality of multiplexer circuits 500B of the shifting manner described with reference to FIG. 10 will be described as an example.

In FIG. 11, "CB" indicates a column block, "# of CSLs" indicates the number of column selection lines, Meta "ON" indicates the first mode Mode 1, and Meta "OFF" indicates the second mode Mode 2. Also, numbers in parentheses below Meta "ON" and Meta "OFF" indicate column addresses.

Meanwhile, D0 to D15 marked at intersections of column blocks and column addresses indicate that data output from a column block or input to a column block are output or input through a multiplexer circuit corresponding to the marked column block. Below, for convenience, the description will be described based on the read operation, but the following description will be applied to the write operation. For example, in the second mode Mode 2, D6 marked at the intersections of the column block D6 and the column addresses from 0 to 35 indicates that data output from the first column block D6 are output for the column addresses from 0 to 35 through the first multiplexer circuit MUX6 corresponding to the first column block D6. Also, D5 marked at the intersections of the column block D6 and the column addresses from 40 to 63 indicates that data output from the first column block D6 are output for the column addresses from 40 to 63 through the first multiplexer circuit MUX5 corresponding to the first column block D5. The above description is also applied to the remaining column blocks and column addresses.

Referring to FIG. 11, in the case of the first mode Mode 1, the 60 column selection lines included in each of the first column blocks D0 to D15 may be respectively mapped to the 60 column addresses from 0 to 59. Also, 60 column selection lines among 64 column selection lines included in the second column block M0 may be respectively mapped to the 60 column addresses from 0 to 59.

Accordingly, in the first mode Mode 1, when one of the column addresses from 0 to 59 is applied, a column selection line corresponding to the applied column address may be activated together in each of the first column blocks D0 to D15 and the second column block M0.

According to the above description, in the first mode Mode 1, the data of the column blocks D0 to D15 and M0 may be input/output through the multiplexer circuits MUX0 to MUX16 respectively corresponding to the column blocks D0 to D15 and M0.

Meanwhile, in the second mode Mode 2, 60 column addresses among the 64 column addresses from 0 to 63 may be mapped to each of the first column blocks D0 to D15. For example, the remaining 60 column addresses from 0 to 35 and from 40 to 63 other than 4 column addresses from 36 to 39 may be mapped to the column block D6. That is, the 60 column addresses from 0 to 35 and from 40 to 63 may be mapped to the first column block D6, separately from the case where the data output from the first column block D6 are output through the first multiplexer circuit MUX5 corresponding to the first column block D5 being an adjacent column block when one of the column addresses from 40 to 63 is applied.

In this case, 4 column addresses not mapped to the first column blocks D0 to D15 may differ for every first column block as marked by "X" and may be mapped by using column selection lines of the second column block M0.

For example, 4 column addresses from 36 to 39 not mapped to the first column block D6 may be mapped to 4 column selection lines included in the second column block M0. In this case, when one of the column addresses from 36 to 39 is applied, 16 column selection lines corresponding to the applied column address may be respectively activated in the 16 column blocks D0 to D5, D7 to D15, and M0 other than the first column block D6.

In this case, as illustrated in FIG. 11, the data output from the first column blocks D0 to D5 may be respectively output through the first multiplexer circuits MUX0 to MUX5. However, the data output from the first column blocks D7 to D15 may be output through the first multiplexer circuits MUX6 to MUX14 respectively corresponding to the first column blocks D6 to D14, and the data output from the second column block M0 may be output through the first multiplexer circuit MUX15 corresponding to the first column block D15.

The first column block D6 is described above as an example, but it may be understood that the above description is also applied to column addresses mapped to the remaining first column blocks and the operation of the memory device 200 according to the column addresses. Meanwhile, the column block P0 of FIG. 11 is the same as that described with reference to FIG. 8, and thus, additional description will be omitted to avoid redundancy.

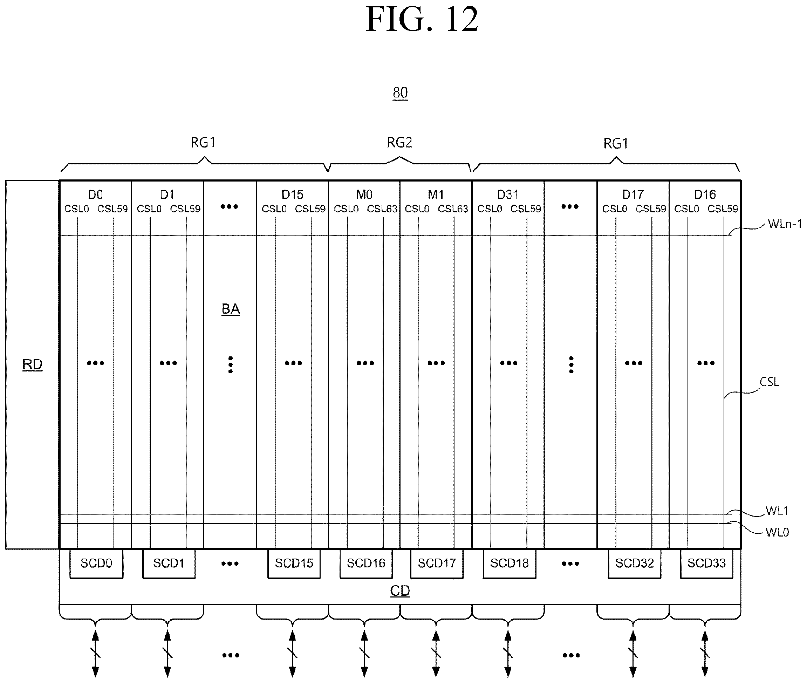

FIG. 12 is a diagram illustrating a bank structure according to an embodiment of the present disclosure. A bank 80 of FIG. 12 may be one of the banks included in the memory device 200 of FIG. 1 or 2, but the present disclosure is not limited thereto.

A single bank structure capable of providing the normal data and the metadata corresponding to the normal data at a ratio of 16:1 is illustrated in FIG. 12 as an example. It is assumed that the bank array BA of FIG. 12 has a page size of 2 KB (kilobyte), a prefetch size is 256 bits, and one column selection line CSL corresponds to 8 bit lines.

Referring to FIG. 12, the bank 80 may include the bank array BA, the row decoder RD corresponding to the bank array BA, and the column decoder CD corresponding to the bank array BA. Also, in FIG. 12, "WL" may indicate a word line, and "CSL" may indicate a column selection line.

In this case, according to an embodiment, the bank array BA may include 32 first column blocks D0 to D31 and 2 second column blocks M0 and M1. The first column blocks D0 to D31 may correspond to the first region RG1 described above, and the second column blocks M0 and M1 may correspond to the second region RG2 described above.

In this case, each of the 32 first column blocks D0 to D31 may include 60 column selection lines CSLO to CSL59, and each of the 2 second column blocks M0 and M1 may include 64 column selection lines CSLO to CSL63.

The row decoder RD may activate a word line corresponding to the applied row address, and the column decoder CD may activate a column selection line corresponding to the applied column address. In this case, according to an embodiment, the column decoder CD may include 34 sub-column decoders SCDO to SCD33 respectively corresponding to the 34 column blocks D0 to D31, M0, and M1, and an operation of each of the column blocks D0 to D31, M0, and M1 may be controlled by the corresponding sub-column decoder. However, the present disclosure is not limited thereto.

The bank 80 may support the operation of the first mode Mode 1 described above. In the first mode Mode 1, the bank 80 may operate based on 60 column addresses respectively corresponding to the 60 column selection lines CSLO to CSL59.

For example, when a column address corresponding to one column selection line (e.g., CSLO) is applied in a state where the first word line WL0 is activated, the column decoder CD may activate the column selection line CSLO in each of the 34 column blocks D0 to D31, M0, and M1. In this case, because each of the activated column selection lines CSLO corresponds to 8 bit lines, 256-bit normal data may be input or output through global input/output lines corresponding to 32 first column blocks D0 to D31 included in the first region RG1. At the same time, 16-bit metadata may be input or output through global input/output lines corresponding to the second column blocks M0 and M1 included in the second region RG2. The above description will also be applied to the remaining 59 column addresses.

According to the above description, like the example illustrated in FIG. 12, the memory device 200 including the bank 80 may operate in the first mode Mode 1 and thus may input or output the 256-bit normal data being the prefetch size and the additional 16-bit metadata through the first region RG1 and the second region RG2. In this case, the number of column addresses capable of being used may be 60.

Also, the bank 80 may support the operation of the second mode Mode 2 described above. In the second mode Mode 2, the bank 80 may operate based on 64 column addresses.

To this end, in the second mode Mode 2, 60 column addresses among the 64 column addresses may be mapped to the column selection lines CSLO to CSL59 of each of the first column blocks D0 to D31. Also, 4 column addresses not mapped to each of the first column blocks D0 to D31 may be mapped by using the column selection lines CSLO to CSL63 included in each of the second column blocks M0 and M1.

According to an embodiment, the 64 column selection lines CSLO to CSL63 included in the second column block M0 among the 2 second column blocks M0 and M1 may provide 64 column addresses not mapped to the first column blocks D0 to D15. Also, the 64 column selection lines included in the second column block M1 may provide the 64 column addresses not mapped to the first column blocks D16 to D31.

In this case, when one column address among the 64 column addresses is applied in a state where the first word line WL0 is activated, two of the first column blocks D0 to D31 need not include a column selection line corresponding to the applied column address. Accordingly, the column decoder CD may activate a column selection line corresponding to the applied column address in each of the remaining first column blocks other than some of the first column blocks D0 to D31 and the second column blocks M0 and M1. In this case, the some of the first column blocks D0 to D31 may include a first column block not including a column selection line corresponding to the applied column address.

Accordingly, because each of the activated column selection lines corresponds to 8 bit lines, 240-bit normal data may be input or output through the global input/output lines respectively corresponding to the 30 first column blocks other than the two first column blocks not including a column selection line corresponding to the applied column address from among the 32 first column blocks D0 to D31 included in the first region RG1. At the same time, 16-bit normal data may be input or output through global input/output lines corresponding to the second column blocks M0 and M1 included in the second region RG2.

According to the above description, like the example illustrated in FIG. 12, the memory device 200 including the bank 80 can operate in the second mode Mode 2 and thus may input or output the 256-bit normal data being the prefetch size through the first region RG1 and the second region RG2. In this case, the number of column addresses capable of being used may be 64.

According to the above embodiment of the present disclosure, the memory device 200 supporting the first mode Mode 1 and the second mode Mode 2 may be provided without the reduction of bus efficiency or the increase in page size. Accordingly, it may be possible to provide the metadata efficiently.

Meanwhile, the bank array BA of the bank 80 may include 2 column block groups disposed to be symmetrical to each other. One of the two column block groups may include the 16 first column blocks D0 to D15 and the second column block M0, and the other thereof may include the 16 first column blocks D16 to D31 and the second column block M1. In this case, each column block group may be similar in structure to the bank array BA of FIG. 5. That is, the bank 80 of FIG. 12 may be seen as the bank 50 of FIG. 5 is expanded to be doubled.

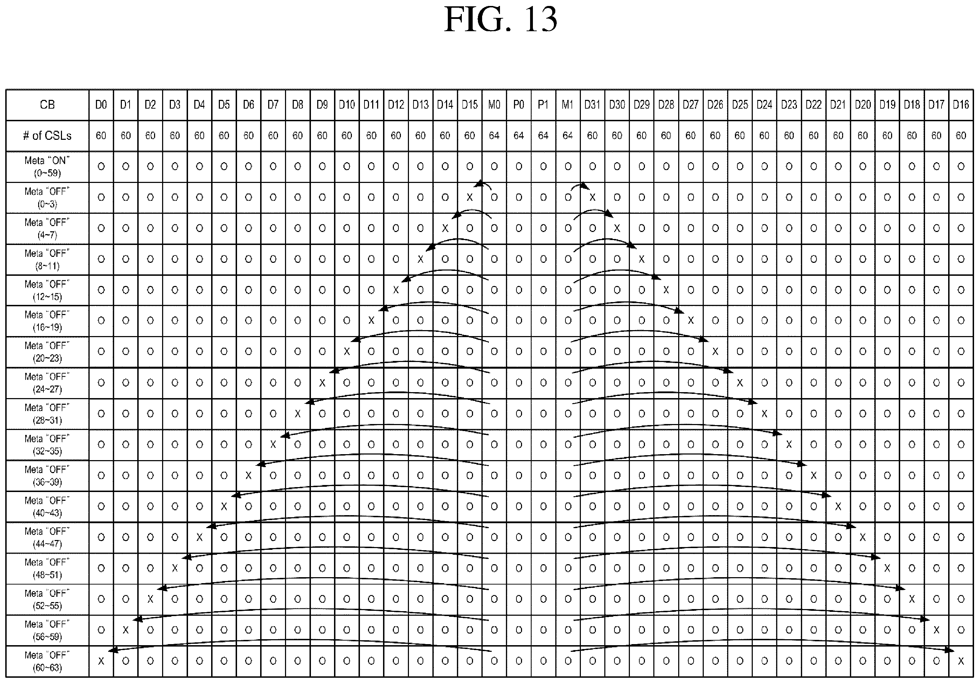

FIG. 13 is a table illustrating a mapping relationship between column selection lines and column addresses according to an embodiment of the present disclosure. The table of FIG. 13 shows a summarized column address mapping relationship of the bank array BA, which is described with reference to FIG. 12, for each mode.

In FIG. 13, "CB" indicates a column block, "# of CSLs" indicates the number of column selection lines, Meta "ON" indicates the first mode Mode 1, and Meta "OFF" indicates the second mode Mode 2. Also, numbers in parentheses below Meta "ON" and Meta "OFF" indicate column addresses.

Referring to FIG. 13, in the case of the first mode Mode 1, the 60 column selection lines included in each of the first column blocks D0 to D31 may be respectively mapped to the 60 column addresses from 0 to 59. Also, 60 column selection lines among the 64 column selection lines included each of the second column blocks M0 and M1 may be respectively mapped to the 60 column addresses from 0 to 59.

Accordingly, in the first mode Mode 1, when one of the column addresses from 0 to 59 is applied, a column selection line corresponding to the applied column address may be activated together in each of the first column blocks D0 to D31 and the second column blocks M0 and M1.

Meanwhile, in the second mode Mode 2, 60 column addresses among the 64 column addresses from 0 to 63 may be mapped to each of the first column blocks D0 to D31. In this case, 4 column addresses not mapped may be mapped by using column selection lines of the second column blocks M0 and M1.

In this case, in the second mode Mode 2, when one of the 64 column addresses is applied, the column decoder CD may activate a column selection line corresponding to the applied column address in each of the remaining first column blocks other than two of the first column blocks D0 to D31 and the second column blocks M0 and M1. In this case, the two first column blocks among the first column blocks D0 to D31 may include first column blocks each not including a column selection line corresponding to the applied column address.

For example, the 60 column addresses from 0 to 35 and from 40 to 63 may be mapped to 60 column selection lines included in each of the first column block D6 and the first column block D22. In this case, 4 column addresses from 36 to 39 not mapped to the first column blocks D6 and D22 may be mapped to 4 column selection lines included in each of the second column blocks M0 and M1. For example, the 4 column addresses from 36 to 39 not mapped to the first column block D6 may be mapped to 4 column selection lines included in the second column block M0, and the 4 column addresses from 36 to 39 not mapped to the first column block D22 may be mapped to 4 column selection lines included in the second column block M1.

In this case, when one of the column addresses from 36 to 39 is applied, 32 column selection lines corresponding to the applied column address may be activated in the 32 column blocks D0 to D5, D7 to D15, M0, M1, D16 to D21, and D23 to D31 other than the first column blocks D6 and D22.

Meanwhile, in FIG. 13, each of the column blocks P0 and P1 may be a column block corresponding to a region, in which parity data are stored, from among regions of the bank array BA. The column blocks P0 and P1 may be included in a separate third region, not included in any of the first region RG1 including the first column blocks D0 to D31 and the second region RG2 including the second column blocks M0 and M1. For example, the parity data corresponding to the column blocks D1 to D15 and M0 may be stored in the column block P0, and the parity data corresponding to the column blocks D16 to D31 and M1 may be stored in the column block P1. According to an embodiment, the column blocks P0 and P1 in which the parity data are stored may be additionally disposed in the bank array BA described with reference to FIG. 12.

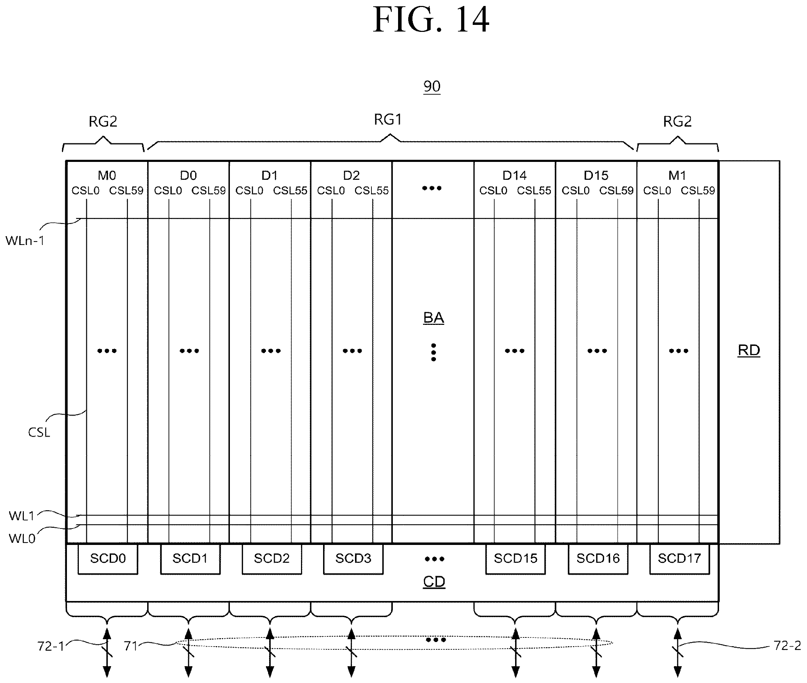

FIG. 14 is a diagram illustrating a bank structure of a memory device according to an embodiment of the present disclosure. A bank 90 of FIG. 14 may be, for example, one of the banks included in the memory device 200 of FIG. 1 or 2, but the present disclosure is not limited thereto.

According to an embodiment of the present disclosure, the memory device 200 may provide the normal data and the metadata corresponding to the normal data at a ratio of 16:1 or at a ratio of 8:1 depending on a mode. A bank structure capable of providing the normal data and the corresponding metadata at a ratio of 16:1 or providing the normal data and the corresponding metadata at a ratio of 8:1 is illustrated as an example in FIG. 14.

It is assumed that the bank array BA of FIG. 14 has a page size of 1 KB (kilobyte), a prefetch size is 128 bits, and one column selection line CSL corresponds to 8 bit lines.

Referring to FIG. 14, the bank 90 may include the bank array BA, the row decoder RD corresponding to the bank array BA, and the column decoder CD corresponding to the bank array BA. Also, in FIG. 14, "WL" may indicate a word line, and "CSL" may indicate a column selection line.

In this case, according to an embodiment, the bank array BA may include 16 first column blocks D0 to D15 and 2 second column blocks M0 and M1. The first column blocks D0 to D15 may correspond to the first region RG1 described above, and the second column blocks M0 and M1 may correspond to the second region RG2 described above.

In this case, each of the first column blocks D1 to D14 among the 16 first column blocks D0 to D15 may include 56 column selection lines CSLO to CSL55, and each of the first column blocks D0 and D15 may include 60 column selection lines CSLO to CSL59. Also, each of the second column blocks M0 and M1 may include 60 column selection lines CSLO to CSL59.

The row decoder RD may activate a word line corresponding to the applied row address, and the column decoder CD may activate a column selection line corresponding to the applied column address. In this case, according to an embodiment, the column decoder CD may include 18 sub-column decoders SCDO to SCD17 respectively corresponding to the 18 column blocks D0 to D15, M0, and M1, and an operation of each of the column blocks D0 to D15, M0, and M1 may be controlled by the corresponding sub-column decoder. However, the present disclosure is not limited thereto.

Meanwhile, the bank 90 may support the operation of the first mode Mode 1 described above. In this case, according to an embodiment, the first mode Mode 1 may include a 16:1 mode and an 8:1 mode. Herein, the 16:1 mode may be a mode in which the normal data and the corresponding metadata are provided at a ratio of 16:1, and the 8:1 mode may be a mode in which the normal data and the corresponding metadata are provided at a ratio of 8:1.

In the 8:1 mode, the bank 90 may operate based on 56 column addresses respectively corresponding to the 56 column selection lines CSLO to CSL55.

For example, when a column address corresponding to one column selection line (e.g., CSLO) is applied in a state where the first word line WL0 is activated, the column decoder CD may activate the column selection line CSLO in each of the 18 column blocks D0 to D15, M0, and M1. In this case, because each of the activated column selection lines CSLO corresponds to 8 bit lines, 128-bit normal data may be input or output through the global input/output lines 71 corresponding to the 16 first column blocks D0 to D15 included in the first region RG1. At the same time, 16-bit metadata may be input or output through global input/output lines 72-1 and 72-2 corresponding to the second column blocks M0 and M1 included in the second region RG2. The above description will also be applied to the remaining 55 column addresses.

According to the above description, like the example illustrated in FIG. 14, the memory device 200 including the bank 90 may operate in the 8:1 mode of the first mode Mode 1 and thus may input or output the 128-bit normal data being the prefetch size and the additional 16-bit metadata through the first region RG1 and the second region RG2. In this case, the number of column addresses capable of being used may be 56.

Meanwhile, in the 16:1 mode, the bank 90 may operate based on 60 column addresses. To support the 60 column addresses, 60 column selection lines corresponding to the 60 column addresses may be required. However, because each of the first column blocks D1 to D14 among the first column blocks D0 to D15 includes only the 56 column selection lines CSLO to CSL55, only 56 column addresses among the 60 column addresses may be mapped to the column selection lines CSLO to CSL55 of each of the first column blocks D1 to D14.

According to embodiments of the present disclosure, to map the remaining 4 column addresses not mapped to the column selection lines CSLO to CSL55 of the first column blocks D1 to D14 in the 16:1 mode, the column selection lines CSLO to CSL59 included in the second column blocks M0 and M1 may be used. In this case, the 4 column addresses not mapped to the 56 column selection lines CSLO to CSL55 of the first column blocks D1 to D14 from among the 60 column addresses may differ for every first column block.

In detail, according to an embodiment, the 4 column addresses not mapped to the column selection lines CSLO to CSL55 of the first column blocks D1 to D14 from among the 60 column addresses may be mapped to 4 column selection lines included in the second column block M0 or M1. In this case, the 60 column selection lines corresponding to the 60 column addresses may include the 56 column selection lines CSLO to CSL55 of each of the first column blocks D1 to D14 and the 4 column selection lines of the second column block M0 or M1.

In this case, when one column address among the 60 column addresses is applied in a state where the first word line WL0 is activated, one of the first column blocks D1 to D14 need not include a column selection line corresponding to the applied column address. Accordingly, the column decoder CD may activate a column selection line corresponding to the applied column address in each of the remaining first column blocks other than some of the first column blocks D1 to D14 and the column blocks D0, D15, M0, and M1. In this case, the some column blocks may include a first column block not including a column selection line corresponding to the applied column address from among the first column blocks D1 to D14.

Accordingly, because each of the activated column selection lines corresponds to 8 bit lines, 120-bit normal data may be input or output through the global input/output lines 71 respectively corresponding to the remaining 15 first column blocks other than one first column block not including a column selection line corresponding to the applied column address from among the 16 first column blocks D0 to D15 included in the first region RG1. Also, 8-bit normal data may be input or output through a global input/output line corresponding to one of the second column block M0 or M1 included in the second region RG2. At the same time, 8-bit metadata may be input or output through a global input/output line corresponding to the other of the second column block M0 or M1.

According to the above description, like the example illustrated in FIG. 14, the memory device 200 including the bank 90 may operate in the 16: 1 mode of the first mode Mode 1 and thus may input or output the 128-bit normal data being the prefetch size and the additional 8-bit metadata through the first region RG1 and the second region RG2. In this case, the number of column addresses capable of being used may be 60.

Meanwhile, the bank 90 may support the operation of the second mode Mode 2 described above. In the second mode Mode 2, the bank 90 may operate based on 64 column addresses.

To support the 64 column addresses, 64 column selection lines corresponding to the 64 column addresses may be required.

However, because each of the first column blocks D1 to D14 among the first column blocks D0 to D15 includes only the 56 column selection lines CSLO to CSL55, only 56 column addresses among the 64 column addresses may be mapped to the column selection lines CSLO to CSL55 of each of the first column blocks D1 to D14. Also, because each of the first column blocks D0 and D15 includes only the 60 column selection lines CSLO to CSL59, only 60 column addresses among the 64 column addresses may be mapped to the column selection lines CSLO to CSL59 of each of the first column blocks D0 and D15.

According to embodiments of the present disclosure, in the second mode Mode 2, to map 8 column addresses not mapped to the column selection lines CSLO to CSL55 of the first column blocks D1 to D14 and 4 column addresses not mapped to the column selection lines CSLO to CSL59 of the first column blocks D0 and D15, the column selection lines CSLO to CSL59 included in the second column blocks M0 and M1 may be used. Because 112 (= 14 * 8) column selection lines are required for column addresses not mapped to the first column blocks D1 to D14 and 8 (= 2 * 4) column selection lines are required for column addresses not mapped to the first column blocks D0 and D15, 120 column selection lines may be required; because the second column blocks M0 and M1 include 120 (= 2*60) column selection lines, all the column addresses not mapped to the first column blocks D0 and D15 may be mapped by using the column selection lines included in the second column blocks M0 and M1.

According to an embodiment, the 60 column selection lines CSLO to CSL59 included in the second column block M0 among the second column blocks M0 and M1 may provide 4 column addresses not mapped to the first column block D0 and 56 column addresses not mapped to the first column blocks D1 to D7. Also, the 60 column selection lines CSLO to CSL59 included in the second column block M1 among the second column blocks M0 and M1 may provide the 4 column addresses not mapped to the first column block D15 and the 56 column addresses not mapped to the first column blocks D8 to D14.

In this case, when one column address among the 64 column addresses is applied in a state where the first word line WL0 is activated, one or two of the first column blocks D0 to D15 need not include a column selection line corresponding to the applied column address. Accordingly, the column decoder CD may activate a column selection line corresponding to the applied column address in each of the remaining first column blocks other than some of the first column blocks D0 to D15 and the second column blocks M0 and M1. In this case, the some of the first column blocks D0 to D15 may include a first column block not including a column selection line corresponding to the applied column address.

In detail, when one first column block does not include a column selection line corresponding to the applied column address, 120-bit normal data may be input or output through global input/output lines respectively corresponding to 15 first column blocks other than one of the 16 first column blocks D0 to D15 included in the first region RG1. At the same time, 8-bit normal data may be input or output through a global input/output line corresponding to one of the second column blocks M0 and M1 included in the second region RG2.

Also, when two first column blocks do not include a column selection line corresponding to the applied column address, 112-bit normal data may be input or output through global input/output lines respectively corresponding to 14 first column blocks other than two of the 16 first column blocks D0 to D15 included in the first region RG1. At the same time, 16-bit normal data may be input or output through the global input/output lines 72-1 and 72-2 corresponding to the second column blocks M0 and M1 included in the second region RG2.

According to the above description, like the example illustrated in FIG. 14, the memory device 200 including the bank 90 can operate in the second mode Mode 2 and thus may input or output the 128-bit normal data being the prefetch size through the first region RG1 and the second region RG2. In this case, the number of column addresses capable of being used may be 64.

According to the above embodiment of the present disclosure, the memory device 200 supporting the first mode Mode 1 and the second mode Mode 2 may be provided without the reduction of bus efficiency or the increase in page size. Accordingly, it may be possible to provide the metadata efficiently. Also, it may be possible to provide a plurality of first modes, in which a metadata providing ratio is variable, through one bank array.

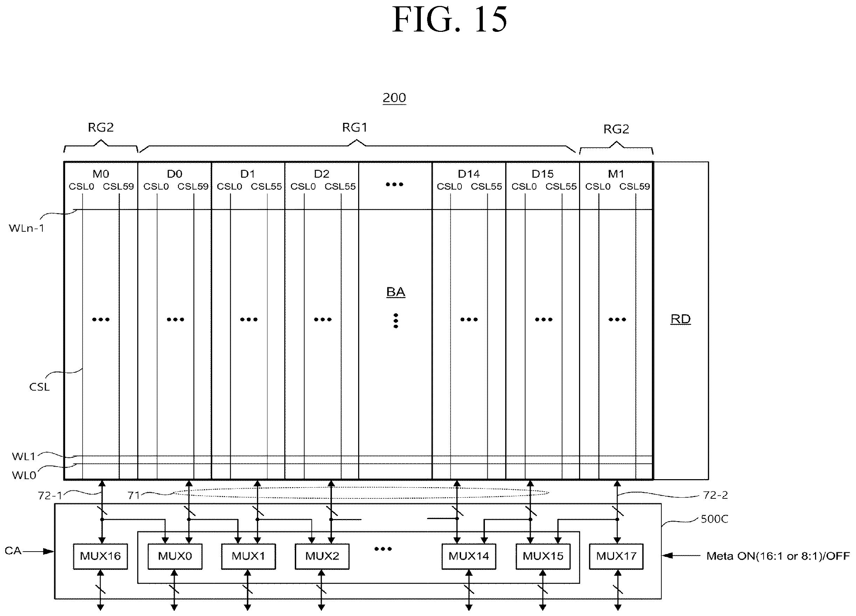

FIG. 15 is a diagram for describing a configuration and an operation of multiplexer circuits according to embodiments of the present disclosure. The bank array BA of FIG. 15 may be the bank array BA of FIG. 14, but the present disclosure is not limited thereto.

Referring to FIG. 15, the memory device 200 may include a plurality of multiplexer circuits 500C for controlling the flow of data input/output to/from the bank array BA. In this case, the plurality of multiplexer circuits 500C may include the plurality of first multiplexer circuits MUX0 to MUX15 respectively corresponding to the plurality of first column blocks D0 to D15 and second multiplexer circuits MUX16 and MUX17 respectively corresponding to the second column blocks M0 and M1.

According to an embodiment, the second multiplexer circuit MUX16 may be connected to the second global input/output line 72-1 connected to the second column block M0. Also, the second multiplexer circuit MUX17 may be connected to the second global input/output line 72-2 connected to the second column block M1.

Also, the first multiplexer circuit MUX0 adjacent to the second multiplexer circuit MUX16 from among the plurality of first multiplexer circuits MUX0 to MUX15 may be connected to the first global input/output line 71 connected to the corresponding first column block D0 and the second global input/output line 72-1. Also, each of the first multiplexer circuits MUX1 to MUX7 among the plurality of first multiplexer circuits MUX0 to MUX15 may be connected to the first global input/output line 71 connected to the corresponding first column block and the first global input/output line 71 connected to the adjacent first column block.

Also, the first multiplexer circuit MUX15 adjacent to the second multiplexer circuit MUX17 from among the plurality of first multiplexer circuits MUX0 to MUX15 may be connected to the first global input/output line 71 connected to the corresponding first column block D15 and the second global input/output line 72-2. Also, each of the first multiplexer circuits MUX8 to MUX14 among the plurality of first multiplexer circuits MUX0 to MUX15 may be connected to the first global input/output line 71 connected to the corresponding first column block and the first global input/output line 71 connected to the adjacent first column block.

For example, when the setting value of the mode register is a value of "Meta ON(8:1)" corresponding to the 8:1 mode of the first mode Mode 1, the second multiplexer circuits MUX16 and MUX17 may input/output data through the connected second global input/output lines 72-1 and 72-2. Also, each of the first multiplexer circuits MUX0 to MUX15 may select the first global input/output line 71 connected to the corresponding first column block from among the connected first global input/output lines and may input/output data through the selected first global input/output line 71.

In this case, in the read operation of the first mode Mode 1, each to the plurality of first multiplexer circuits MUX0 to MUX15 may output the applied output data to the first global input/output line 71 connected to the corresponding first column block, the second multiplexer circuit MUX16 may output the applied output data to the second global input/output line 72-1, and the second multiplexer circuit MUX17 may output the applied output data to the second global input/output line 72-2. Also, in the write operation of the first mode Mode 1, each of the plurality of first multiplexer circuits MUX0 to MUX15 may apply the input data to the first global input/output line 71 connected to the corresponding first column block, the second multiplexer circuit MUX16 may apply the input data to the second global input/output line 72-1, and the second multiplexer circuit MUX17 may apply the input data to the second global input/output line 72-2.

Meanwhile, when the setting value of the mode register is a value of "Meta ON(16:1)" corresponding to the 16:1 mode of the first mode Mode 1, each of the plurality of first multiplexer circuits MUX0 to MUX15 may select one of the connected global input/output lines based on the applied column address CA and may input/output data through the selected global input/output line. Also, based on the applied column address CA, the second multiplexer circuits MUX16 and MUX17 may input/output data through the second global input/output lines 72-1 and 72-2 or need not input/output data through the second global input/output lines 72-1 and 72-2.

According to an embodiment, in the 16:1 mode, a first multiplexer circuit (hereinafter referred to "C") corresponding to a first column block, to which the applied column address CA is not mapped, from among the plurality of first multiplexer circuits MUX0 to MUX15 may select a global input/output line connected to the adjacent column block from among the connected global input/output lines.

In this case, each of first multiplexer circuits (hereinafter referred to as "D") between the "C" and the second multiplexer circuits MUX16 or MUX17 may also select a global input/output line connected to the adjacent column block from among the connected global input/output lines. In detail, when the "C" is any one of the first multiplexer circuits MUX0 to MUX7, each of first multiplexer circuits between the "C" and the second multiplexer circuit MUX16 may select a global input/output line connected to the adjacent column block. Also, when the "C" is any one of the first multiplexer circuits MUX8 to MUX15, each of first multiplexer circuits between the "C" and the second multiplexer circuit MUX17 may select a global input/output line connected to the adjacent column block.

Meanwhile, each of the remaining first multiplexer circuits among the plurality of first multiplexer circuits MUX0 to MUX15 other than the "C" and the "D" may select a first global input/output line connected to the corresponding first column block from among the connected global input/output lines.

Meanwhile, when the setting value of the mode register is a value of "Meta OFF" corresponding to the second mode Mode 2, each of the plurality of first multiplexer circuits MUX0 to MUX15 may select one of the connected global input/output lines based on the applied column address CA and may input/output data through the selected global input/output line. In this case, the second multiplexer circuits MUX16 and MUX17 need not input/output data through the connected second global input/output lines72-1 and 72-2.

According to an embodiment, in the second mode Mode 2, a first multiplexer circuit (hereinafter referred to "E") corresponding to a first column block, to which the applied column address CA is not mapped, from among the plurality of first multiplexer circuits MUX0 to MUX15 may select a global input/output line connected to the adjacent column block from among the connected global input/output lines.

In this case, each of first multiplexer circuits (hereinafter referred to as "F") between the "E" and the second multiplexer circuits MUX16 or MUX17 may also select a global input/output line connected to the adjacent column block from among the connected global input/output lines. In detail, when the "E" is any one of the first multiplexer circuits MUX0 to MUX7, each of first multiplexer circuits between the "E" and the second multiplexer circuit MUX16 may select a global input/output line connected to the adjacent column block. Also, when the "E" is any one of the first multiplexer circuits MUX8 to MUX15, each of first multiplexer circuits between the "E" and the second multiplexer circuit MUX17 may select a global input/output line connected to the adjacent column block.

Meanwhile, each of the remaining first multiplexer circuits among the plurality of first multiplexer circuits MUX0 to MUX15 other than the "E" and the "F" may select a first global input/output line connected to the corresponding first column block from among the connected global input/output lines.

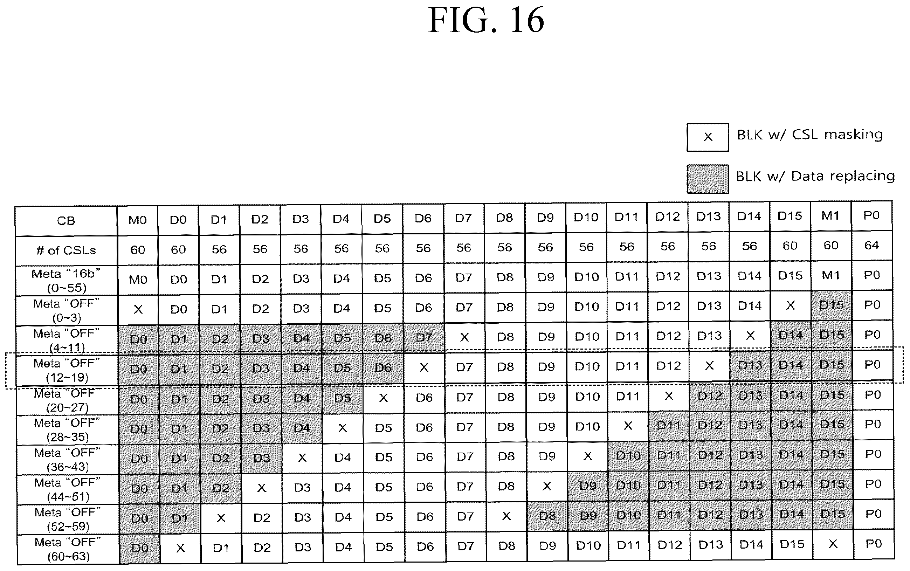

FIG. 16 is a diagram for describing a mapping relationship between column selection lines and column addresses according to an embodiment of the present disclosure. In FIG. 16, the case where the memory device 200 includes the plurality of multiplexer circuits 500C of the shifting manner described with reference to FIG. 15 will be described as an example.

In FIG. 16, "CB" indicates a column block, "# of CSLs" indicates the number of column selection lines, Meta "16b" indicates the 8:1 mode of the first mode Mode 1, and Meta "OFF" indicates the second mode Mode 2. Also, numbers in parentheses below Meta "16b" and the Meta "OFF" indicate column addresses.

Meanwhile, D0 to D15 marked at intersections of column blocks and column addresses indicate that data output from a column block or input to a column block are output or input through a first multiplexer circuit corresponding to the marked column block. For example, in the second mode Mode 2, D2 marked at the intersections of the column block D2 and the column addresses from 0 to 3 indicates that data output from the first column block D2 are output for the column addresses from 0 to 3 through the first multiplexer circuit MUX2 corresponding to the first column block D2. Also, D14 marked at the intersections of the column block D15 and the column addresses from 20 to 27 indicates that data output from the first column block D15 are output for the column addresses from 20 to 27 through the first multiplexer circuit MUX14 corresponding to the first column block D14. The above description is also applied to the remaining column blocks and column addresses.

As described above, in the 8:1 mode of the first mode Mode 1, the memory device 200 may operate based on 56 column addresses. Referring to FIG. 16, in the case of the 8:1 mode of the first mode Mode 1, the 56 column selection lines included in the first column blocks D1 to D14 may be respectively mapped to the 56 column addresses from 0 to 55. Also, 56 column selection lines among 60 column selection lines included in the second column blocks D0 and D15 may be respectively mapped to the 56 column addresses from 0 to 55. Also, 56 column selection lines among the 60 column selection lines included the second column blocks M0 and M1 may be respectively mapped to the 56 column addresses from 0 to 55.

Accordingly, in the 8:1 mode, when one of the column addresses from 0 to 55 is applied, a column selection line corresponding to the applied column address may be selected together in each of the first column blocks D0 to D15 and the second column blocks M0 and M1.

According to the above description, in the 8:1 mode, the data of the column blocks D0 to D15, M0, and M1 may be input/output through the multiplexer circuits MUX0 to MUX17 respectively corresponding to the column blocks D0 to D15, M0, and M1.

Meanwhile, as described above, in the second mode Mode 2, the memory device 200 may operate based on 64 column addresses. Referring to FIG. 16, in the second mode Mode 2, 56 column addresses among the 64 column addresses from 0 to 63 may be mapped to each of the first column blocks D1 to D14. For example, the remaining 56 column addresses from 0 to 11 and from 20 to 63 other than 8 column addresses from 12 to 19 marked by "X" may be mapped to the column block D6. The above description is also applied to the column block D13. As another example, the remaining 56 column addresses from 0 to 51 and from 60 to 63 other than 8 column addresses from 52 to 59 marked by "X" may be mapped to the column blocks D1 and D8.

Also, in the second mode Mode 2, 60 column addresses among the 64 column addresses from 0 to 63 may be mapped to each of the first column blocks D0 and D15. For example, the 60 column addresses from 0 to 59 other than the 4 column addresses from 60 to 63 marked by "X" may be mapped to the column block D0, and the 60 column addresses from 4 to 63 other than the 4 column addresses from 0 to 3 marked by "X" may be mapped to the column block D15.

In this case, column addresses not mapped to the first column blocks D0 to D7 may be mapped by using column selection lines included in the second column block M0. Also, column addresses not mapped to the first column blocks D8 to D15 may be mapped by using column selection lines included in the second column block M1.

In detail, because the number of column selection lines for mapping column addresses not mapped to the first column blocks D0 to D7 is 4 in the column block D0 and is 56 in the column blocks D1 to D7, the sum may be 60; because the second column block M0 includes 60 column selection lines, column addresses not mapped to the first column blocks D0 to D7 may be mapped by using the column selection lines included in the second column block M0. Also, because the number of column selection lines for mapping column addresses not mapped to the first column blocks D8 to D15 is 4 in the column block D15 and is 56 in the column blocks D8 to D14, the sum may be 60; because the second column block M1 includes 60 column selection lines, column addresses not mapped to the first column blocks D8 to D15 may be mapped by using the column selection lines included in the second column block M1.

In this case, for example, when one of the column addresses from 12 to 19 is applied, 16 column selection lines corresponding to the applied column address may be respectively activated in the 16 column blocks D0 to D5, D7 to D12, D14, D15, M0, and M1 other than the first column blocks D6 and D13.

In this case, as illustrated in FIG. 16, the data output from the M0 and D0 to D5 may be respectively output through the first multiplexer circuits MUX0 to MUX6 corresponding to the first column blocks D0 to D6. Also, the data output from the D14, D15, and M1 may be output through the first multiplexer circuits MUX13 to MUX15 corresponding to the first column blocks D13 to D15. Meanwhile, the data output from the first column blocks D7 to D12 may be respectively output through the first multiplexer circuits MUX7 to MUX12 respectively corresponding to the first column blocks D7 to D12.

The case where one of the column addresses from 12 to 19 is applied is described above as an example, but operations which are performed when any other column address among the 64 column addresses is applied may be sufficiently understood from the description given with reference to FIGS. 15 and 16.

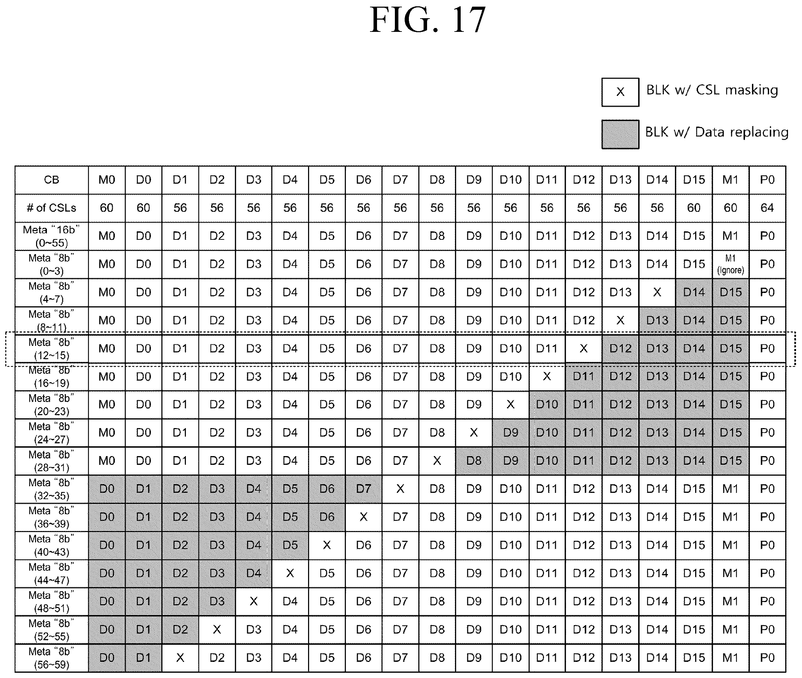

FIG. 17 is a diagram for describing a mapping relationship between column selection lines and column addresses according to an embodiment of the present disclosure. In FIG. 17, the case where the memory device 200 includes the plurality of multiplexer circuits 500C of the shifting manner described with reference to FIG. 15 will be described as an example.

In FIG. 17, "CB" indicates a column block, "# of CSLs" indicates the number of column selection lines, Meta "16b" indicates the 8:1 mode of the first mode Mode 1, and Meta "8b" indicates the 16:1 mode of the first mode Mode 1. Also, numbers in parentheses below Meta "16b" and the Meta "8b" indicate column addresses. Meanwhile, as described above, D0 to D15 marked at intersections of column blocks and column addresses indicate that data output from a column block or input to a column block are output or input through a first multiplexer circuit corresponding to the marked column block. In FIG. 17, the 8:1 mode of the first mode Mode 1 is described with reference to FIG. 16, and thus, additional description will be omitted to avoid redundancy.

As described above, in the 16:1 mode of the first mode Mode 1, the memory device 200 may operate based on 60 column addresses.

In the 16:1 mode, 60 column addresses from 0 to 59 may be mapped to each of the first column blocks D0 and D15.

Also, in the 16:1 mode, 56 column addresses among the 60 column addresses from 0 to 59 may be mapped to each of the first column blocks D1 to D14. For example, the remaining 56 column addresses from 0 to 35 and from 40 to 59 other than 4 column addresses from 36 to 39 marked by "X" may be mapped to the column block D6. Also, the remaining 56 column addresses from 0 to 55 other than 4 column addresses from 56 to 59 marked by "X" may be mapped to the column block D1.

In this case, column addresses not mapped to the first column blocks D1 to D7 may be mapped by using column selection lines included in the second column block M0. Also, column addresses not mapped to the first column blocks D8 to D14 may be mapped by using column selection lines included in the second column block M1.

In detail, because the number of column selection lines for mapping column addresses not mapped to the first column blocks D1 to D7 is 28 in the column blocks D1 to D7, column addresses not mapped to the first column blocks D1 to D7 may be mapped by using 28 column selection lines among the 60 column selection lines included in the second column block M0. Also, because the number of column selection lines for mapping column addresses not mapped to the first column blocks D8 to D14 is 28 in the column blocks D8 to D14, column addresses not mapped to the first column blocks D8 to D14 may be mapped by using 28 column selection lines among the 60 column selection lines included in the second column block M1.

Meanwhile, 60 column addresses may be mapped to 64 column selection lines other than 56 column selection lines used to map the column addresses not mapped to the column blocks D1 to D14 from among the 120 column selection lines included in the second column blocks M0 and M1. In the example of FIG. 17, 32 column addresses from 0 to 31 may be mapped to 32 column selection lines included in the second column block M0, and 28 column addresses from 32 to 59 may be mapped to 28 column selection lines among the 32 column selection lines included in the second column block M1. The remaining column addresses of the second column block M1 may be ignored.

In this case, for example, when one of the column addresses from 12 to 15 is applied, 17 column selection lines corresponding to the applied column address may be respectively activated in the 17 column blocks D0 to D11, D13 to D15, M0, and M1 other than the first column block D12.

In this case, as illustrated in FIG. 17, the data output from the M0 may be output through the second multiplexer circuit MUX16 corresponding to the second column block M0, and the data output from the first column blocks D0 to D11 may be respectively output through the first multiplexer circuits MUX0 to MUX11 corresponding to the first column blocks D0 to D11. Also, the data output from the first column blocks D13 to D15 may be output through the first multiplexer circuits MUX12 to MUX14 corresponding to the first column blocks D12 to D14. Also, the data output from the second column block M1 may be output through the first multiplexer circuit MUX15 corresponding to the first column block D15.

The case where one of the column addresses from 12 to 15 is applied is described above as an example, but operations which are performed when any other column address among the 60 column addresses is applied may be sufficiently understood from the description given with reference to FIGS. 15 and 17.

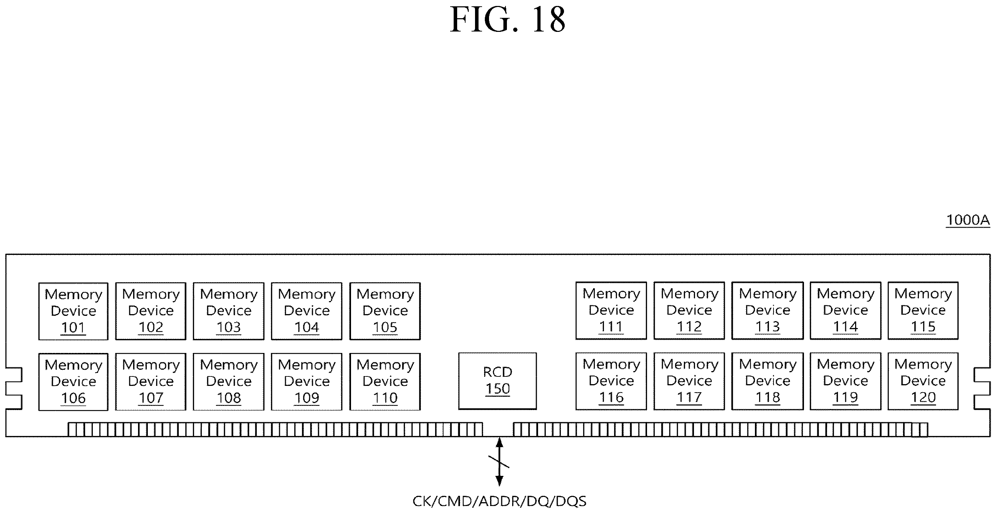

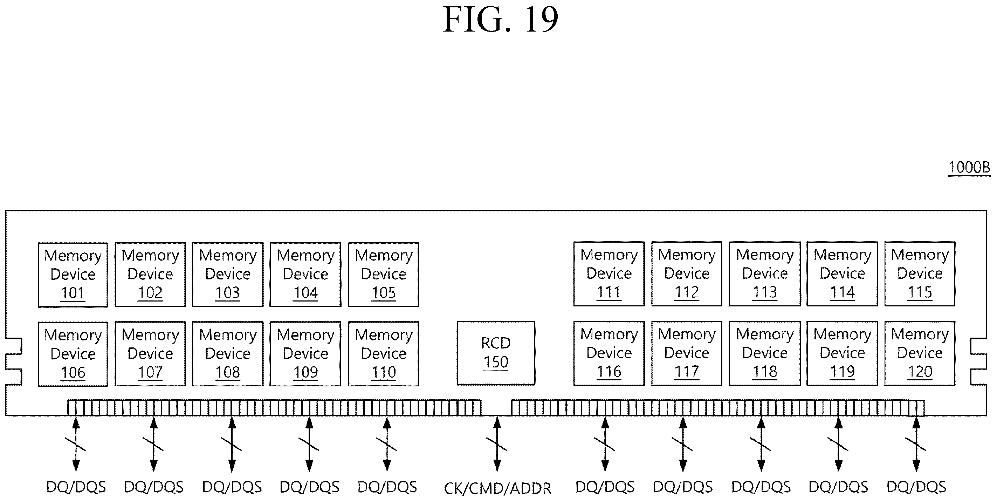

FIGS. 18 and 19 are diagrams illustrating a memory module according to an embodiment of the present disclosure.

Referring to FIGS. 18 and 19, each of memory modules 1000A and 1000B may include a plurality of memory devices 101 to 120 and a register clock driver (RCD) 150. The plurality of memory devices 101 to 120 may be disposed to be separated on the left side and the right side with respect to the register clock driver 150.

The memory modules 1000A and 1000B may be the DIMM complying with the JEDEC standard. For example, the memory module 1000A may be a registered DIMM (RDIMM), a load reduced DIMM (LRDIMM), an unbuffered DIMM (UDIMM), a fully buffered DIMM (FB-DIMM), a small outline DIMM (SO-DIMM), or any other memory module (e.g., SIMM).

Each of the memory devices 101 to 120 may be the memory device 200 described with reference to FIGS. 1 to 17. The memory devices 101 to 120 may be various DRAM devices such as a DDR SDRAM, an LPDDR SDRAM, and a GDDR SGRAM. Alternatively, the memory devices 101 to 120 may be an SRAM device, a NAND flash memory device, a NOR flash memory device, an RRAM device, an FRAM device, a PRAM device, a TRAM device, an MRAM device, etc. Kinds of memory devices 101 to 120 may be identical to each other or may be different from each other.

The number of memory devices 101 to 120 included in each of the memory modules 1000A and 1000B is provided as an example, and the number of memory devices 101 to 120 may be determined depending on a memory capacity provided to the user and the capacity of each of the memory devices 101 to 120.

According to an embodiment, as illustrated in FIG. 18, the plurality of memory devices 101 to 120 may share a transfer path for a clock CK, a command CMD, an address signal ADDR, a data signal DQ, and a data strobe signal DQS.

In this case, the register clock driver 150 may receive the clock CK, the command CMD, the address signal ADDR, the data signal DQ, and the data strobe signal DQS from the memory controller 100 (refer to FIG. 1). The register clock driver 150 may control the memory devices 101 to 120 based on the clock CK, the command CMD, the address signal ADDR, the data signal DQ, and the data strobe signal DQS. The register clock driver 150 may perform a buffer role for the clock CK, the command CMD, the address signal ADDR, the data signal DQ, and the data strobe signal DQS.

According to an embodiment, as illustrated in FIG. 19, the plurality of memory devices 101 to 120 may share transfer paths for the clock CK, the command CMD, and the address signal ADDR but need not share a transfer path for the data signal DQ and the data strobe signal DQS. That is, the plurality of memory devices 101 to 120 may receive the data signal DQ and the data strobe signal DQS from the memory controller 100 (refer to FIG. 1) independently of each other. According to the above description, the memory controller 100 may set operation modes of the plurality of memory devices 101 to 120 independently of each other.

In this case, the register clock driver 150 may receive the clock CK, the command CMD, and the address signal ADDR from the memory controller 100. The register clock driver 150 may perform a buffer role for the clock CK, the command CMD, and the address signal ADDR.

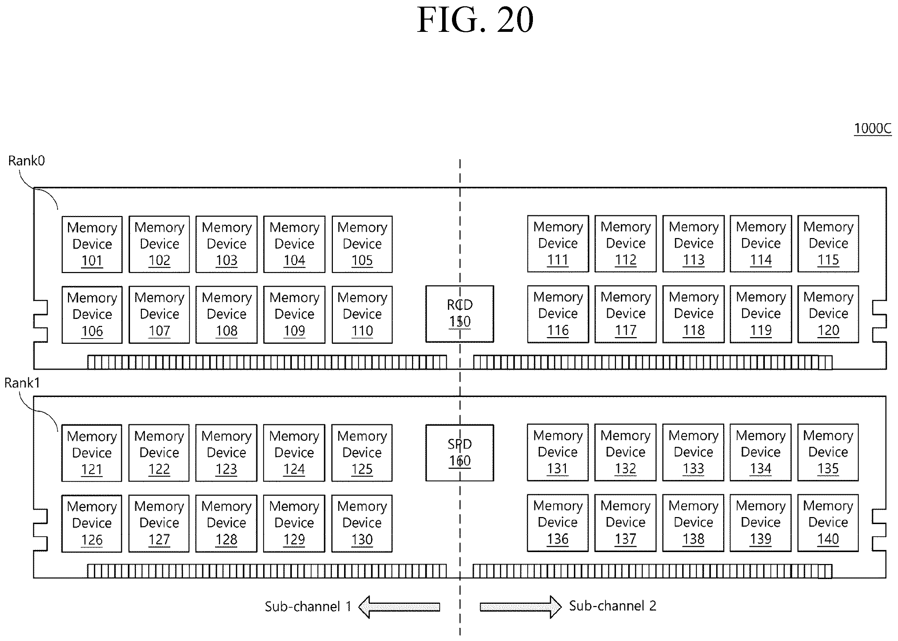

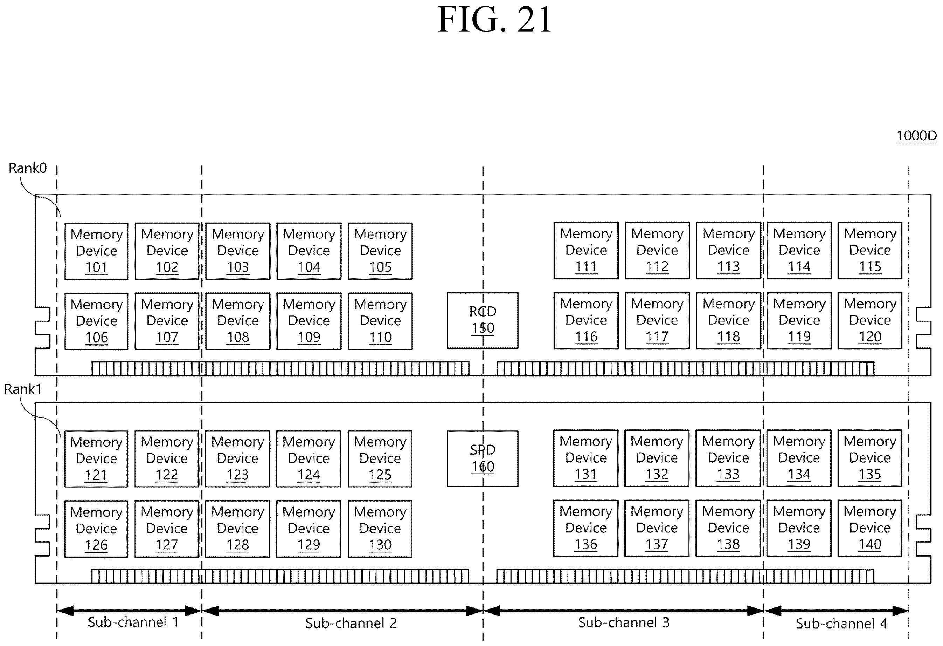

Also, according to an embodiment, as illustrated in FIGS. 20 and 21 to be described below, a memory module may communicate with the memory controller 100 through sub-channels different from each other.

FIGS. 20 and 21 are diagrams illustrating an example of a memory module according to an embodiment of the present disclosure.

First, referring to FIG. 20, a memory module 1000C may include a plurality of memory devices 101 to 140 disposed on opposite surfaces thereof. Each of the memory devices 101 to 140 may be the memory device 200 described with reference to FIGS. 1 to 17.

Also, the plurality of memory devices 101 to 120 disposed on the first surface of the memory module 1000C may be disposed to be separated on the left side and the right side with respect to the register clock driver 150. The plurality of memory devices 121 to 140 disposed on the second surface of the memory module 1000C may be disposed to be separated on the left side and the right side with respect to an SPD 160.

Memory devices of the memory module 1000C may communicate with the memory controller 100 through two sub-channels. For example, the memory devices 101 to 110 and 121 to 130 disposed on the left side of the memory module 1000C may communicate with the memory controller 100 (refer to FIG. 1) through a first sub-channel Sub_Channel 1. The memory devices 111 to 120 and 131 to 140 disposed on the right side of the memory module 1000C may communicate with the memory controller 100 through a second sub-channel Sub_Channel 2.

Referring to FIG. 21, a memory module 1000D may include the plurality of memory devices 101 to 140 disposed on opposite surfaces thereof. Each of the memory devices 101 to 140 may be the memory device 200 described with reference to FIGS. 1 to 17.

Also, the plurality of memory devices 101 to 120 disposed on the first surface of the memory module 1000D may be disposed to be separated on the left side and the right side with respect to the register clock driver 150. The plurality of memory devices 121 to 140 disposed on the second surface of the memory module 1000D may be disposed to be separated on the left side and the right side with respect to the SPD 160.

Memory devices of the memory module 1000D may communicate with the memory controller 100 through four sub-channels. For example, the memory devices 101, 102, 106, 107, 121, 122, 126, and 127 disposed on the leftmost side of the memory module 1000D may communicate with the memory controller 100 through a first sub-channel Sub_Channel 1. The memory devices 103, 104, 108, 109, 123, 124, 128, and 129 disposed on the left side of the memory module 1000D may communicate with the memory controller 100 through a second sub-channel Sub_Channel 2.

The memory devices 114, 115, 119, 120, 134, 135, 139, and 140 disposed on the rightmost side of the memory module 1000D may communicate with the memory controller 100 through a fourth sub-channel Sub_Channel 4. The memory devices 112, 113, 117, 118, 132, 133, 137, and 138 disposed on the right side of the memory module 1000D may communicate with the memory controller 100 through a third sub-channel Sub_Channel 3.

Meanwhile, some memory devices 105, 110, 111, 116, 125, 130, 131, and 136 may be allocated for a chip for the ECC operation or may communicate with the memory controller 100 through the second or third sub-channel Sub_Channel 2 or Sub_Channel 3.

According to the above embodiment of the present disclosure, the memory device 200 operating in the first mode Mode 1 or the second mode Mode 2 may be provided without the reduction of bus efficiency or the increase in power consumption. Accordingly, it may be possible to provide the metadata efficiently.

According to the above embodiments of the present disclosure, there may be provided a memory device which provides metadata efficiently.

While the present disclosure has been described with reference to embodiments thereof, it will be apparent to those of ordinary skill in the art that various changes and modifications may be made thereto without departing from the scope of the present disclosure as set forth in the following claims.
Embodiments of the invention are set out in the following clauses:
Clause 1. A memory device comprising: a bank array including a plurality of memory cells; a row decoder connected to the bank array through a plurality of word lines; and a column decoder connected to the bank array through a plurality of column selection lines, wherein the bank array includes: a first region and a second region different from the first region, wherein
the memory device is configured to operate in a first mode, in which the first region is configured to store normal data and the second region is configured to store metadata based on a first number of column addresses, respectively, wherein the memory device is configured to operate in a second mode, in which the first region and the second region are configured to store normal data based on a second number of column addresses, and wherein the second number is greater than the first number.
Clause 2. The memory device of clause 1, wherein the first region includes a plurality of first column blocks, wherein the second region includes at least one second column block, wherein each of the plurality of first column blocks includes first column selection lines as many as the first number of column addresses, and wherein each of the at least one second column block includes second column selection lines as many as a third number being equal to or greater than the first number of column addresses.
Clause 3. The memory device of clause 2, wherein, in the first mode, the column decoder, in response to receiving one column address among the first number of column addresses, is configured to select a column selection line corresponding to the received column address in each of the plurality of first column blocks and each of the at least one second column block.
Clause 4. The memory device of clause 2 or 3, wherein, in the second mode, the column decoder, in response to receiving one column address among the second number of column addresses, is configured to select a column selection line corresponding to the received column address in each of remaining first column blocks other than some of the plurality of first column blocks and each of the at least one second column block, and wherein the some of the plurality of first column blocks include a first column block not including the column selection line corresponding to the received column address.
Clause 5. The memory device of clauses 2, 3, or 4, wherein the first number of first column selection lines included in each of the plurality of first column blocks corresponds to the first number of column addresses in the first mode, and wherein the first number of second column selection lines among the third number of second column selection lines included in each of the at least one second column block corresponds to the first number of column addresses in the first mode.
Clause 6. The memory device of any one previous clause, wherein, in the second mode, the second number of column selection lines corresponding to the second number of column addresses include the first number of first column selection lines and a fourth number of second column selection lines, and wherein the fourth number is a difference between the second number and the first number.
Clause 7. The memory device of clause 6, wherein, in the second mode, the fourth number of column addresses not corresponding to the first number of first column selection lines from among the second number of column addresses differ for every first column block.
Clause 8. The memory device of any one previous clause, further comprising: a plurality of first multiplexer circuits respectively corresponding to the plurality of first column blocks; and at least one second multiplexer circuit respectively corresponding to the at least one second column block, wherein each of the at least one second multiplexer circuit is connected to a second global input/output line connected to the corresponding second column block, and wherein each of the plurality of first multiplexer circuits is connected to a first global input/output line connected to the corresponding first column block and the second global input/output line.
Clause 9. The memory device of clause 8, wherein, in the second mode, each of the plurality of first multiplexer circuits, in response to receiving one column address among the second number of column addresses, is configured to select one of the first and second global input/output lines connected to a corresponding first multiplexer circuit, based on the received column address.
Clause 10. The memory device of any one previous clause, further comprising:
   a plurality of first multiplexer circuits respectively corresponding to the plurality of first column blocks; and at least one second multiplexer circuit respectively corresponding to the at least one second column block, wherein each of the at least one second multiplexer circuit is connected to a second global input/output line connected to the corresponding second column block,
   wherein at least one first multiplexer circuit among the plurality of first multiplexer circuits is connected to a first global input/output line connected to the corresponding first column block and the second global input/output line, and wherein each of remaining first multiplexer circuits other than the at least one first multiplexer circuit among the plurality of first multiplexer circuits is connected to a first global input/output line connected to the corresponding first column block and a first global input/output line connected to an adjacent first column block.
Clause 11. The memory device of clause 10, wherein, in the second mode, each of the plurality of first multiplexer circuits, in response to receiving one column address among the second number of column addresses, is configured to select one of global input/output lines connected to a corresponding first multiplexer circuit, based on the received column address.
Clause 12. The memory device of any one previous clause, further comprising: a mode register for setting the first mode or the second mode.
Clause 13. The memory device of any one previous clause, wherein the bank array further includes: a third region configured to store parity data for error correction.
Clause 14. The memory device of any one previous clause, wherein the first region and the second region are connected in common to the plurality of word lines.
Clause 15. A memory device comprising: a bank array including a first region and a second region; a row decoder connected to the first region and the second region through a plurality of word lines disposed to cross the first region and the second region; and a column decoder connected to the first region through column selection lines disposed in the first region and connected to the second region through column selection lines disposed in the second region, wherein the memory device is configured to operate in a first mode, in which the first region is configured to store normal data and the second region is configured to store metadata based on a first number of column addresses, respectively, wherein the memory device is configured to operate in a second mode, in which the first region and the second region are configured to store normal data based on a second number of column addresses, and wherein the second number is greater than the first number.
Clause 16. The memory device of clause 15, wherein the first region includes a plurality of first column blocks each including first column selection lines as many as the first number of column addresses, wherein the second region includes at least one second column block each including a third number of second column selection lines, and wherein the third number is equal to or greater than the first number of column addresses.
Clause 17. The memory device of clause 16, wherein the first number of first column selection lines included in each of the plurality of first column blocks respectively correspond to the first number of column addresses in the first mode, and wherein the first number of second column selection lines among the third number of second column selection lines included in each of the at least one second column block respectively correspond to the first number of column addresses in the first mode.
Clause 18. The memory device of clause 16 or 17, wherein, in the second mode, the second number of column selection lines corresponding to the second number of column addresses include the first number of first column selection lines and a fourth number of second column selection lines, and wherein the fourth number is a difference between the second number and the first number.
Clause 19. The memory device of clause 18, wherein, in the second mode, the fourth number of column addresses not corresponding to the first number of first column selection lines from among the second number of column addresses differ for every first column block.
Clause 20. A memory module comprising: a plurality of memory devices, wherein each of the plurality of memory devices includes: a bank array including a plurality of memory cells; a row decoder connected to the bank array through a plurality of word lines; and a column decoder connected to the bank array through a plurality of column selection lines, wherein the bank array includes: a first region and a second region different from the first region, wherein one of the plurality of memory devices is configured to operate in a first mode, in which the first region is configured to store normal data and the second region is configured to store metadata based on a first number of column addresses, respectively, wherein the one of the plurality of memory devices is configured to operate in a second mode, in which each of the first and second regions stores normal data based on a second number of column addresses, and wherein the second number is greater than the first number.

## Claims

1. A memory device comprising:
a bank array including a plurality of memory cells;
a row decoder connected to the bank array through a plurality of word lines; and
a column decoder connected to the bank array through a plurality of column selection lines,
wherein the bank array includes:
a first region and a second region different from the first region,
wherein the memory device is configured to operate in a first mode, in which the first region is configured to store normal data and the second region is configured to store metadata based on a first number of column addresses, respectively,
wherein the memory device is configured to operate in a second mode, in which the first region and the second region are configured to store normal data based on a second number of column addresses, and
wherein the second number is greater than the first number.

2. The memory device of claim 1, wherein the first region includes a plurality of first column blocks,
wherein the second region includes at least one second column block,
wherein each of the plurality of first column blocks includes first column selection lines as many as the first number of column addresses, and
wherein each of the at least one second column block includes second column selection lines as many as a third number being equal to or greater than the first number of column addresses.

3. The memory device of claim 2, wherein, in the first mode, the column decoder, in response to receiving one column address among the first number of column addresses, is configured to select a column selection line corresponding to the received column address in each of the plurality of first column blocks and each of the at least one second column block.

4. The memory device of claim 2 or 3, wherein, in the second mode, the column decoder, in response to receiving one column address among the second number of column addresses, is configured to select a column selection line corresponding to the received column address in each of remaining first column blocks other than some of the plurality of first column blocks and each of the at least one second column block, and
wherein the some of the plurality of first column blocks include a first column block not including the column selection line corresponding to the received column address.

5. The memory device of claim 2, 3, or 4 wherein the first number of first column selection lines included in each of the plurality of first column blocks corresponds to the first number of column addresses in the first mode, and
wherein the first number of second column selection lines among the third number of second column selection lines included in each of the at least one second column block corresponds to the first number of column addresses in the first mode.

6. The memory device of any one of claims 2 to 5, wherein, in the second mode, the second number of column selection lines corresponding to the second number of column addresses include the first number of first column selection lines and a fourth number of second column selection lines, and
wherein the fourth number is a difference between the second number and the first number.

7. The memory device of claim 6, wherein, in the second mode, the fourth number of column addresses not corresponding to the first number of first column selection lines from among the second number of column addresses differ for every first column block.

8. The memory device of any one of claims 2 to 7, further comprising:
a plurality of first multiplexer circuits respectively corresponding to the plurality of first column blocks; and
at least one second multiplexer circuit respectively corresponding to the at least one second column block,
wherein each of the at least one second multiplexer circuit is connected to a second global input/output line connected to the corresponding second column block, and
wherein each of the plurality of first multiplexer circuits is connected to a first global input/output line connected to the corresponding first column block and the second global input/output line.

9. The memory device of claim 8, wherein, in the second mode, each of the plurality of first multiplexer circuits, in response to receiving one column address among the second number of column addresses, is configured to select one of the first and second global input/output lines connected to a corresponding first multiplexer circuit, based on the received column address.

10. The memory device of any one of claims 2 to 9, further comprising:
a plurality of first multiplexer circuits respectively corresponding to the plurality of first column blocks; and
at least one second multiplexer circuit respectively corresponding to the at least one second column block,
wherein each of the at least one second multiplexer circuit is connected to a second global input/output line connected to the corresponding second column block,
wherein at least one first multiplexer circuit among the plurality of first multiplexer circuits is connected to a first global input/output line connected to the corresponding first column block and the second global input/output line, and
wherein each of remaining first multiplexer circuits other than the at least one first multiplexer circuit among the plurality of first multiplexer circuits is connected to a first global input/output line connected to the corresponding first column block and a first global input/output line connected to an adjacent first column block.

11. The memory device of claim 10, wherein, in the second mode, each of the plurality of first multiplexer circuits, in response to receiving one column address among the second number of column addresses, is configured to select one of global input/output lines connected to a corresponding first multiplexer circuit, based on the received column address.

12. The memory device of claim 1, further comprising, a mode register for setting the first mode or the second mode.

13. The memory device of claim 1, wherein the bank array further includes, a third region configured to store parity data for error correction.

14. The memory device of claim 1, wherein the first region and the second region are connected in common to the plurality of word lines.

15. The memory device as claimed in any one preceding claim, wherein:
the row decoder is connected to the first region and the second region through the plurality of word lines and the word lines are disposed to cross the first region and the second region; and
the column decoder is connected to the first region through the column selection lines disposed in the first region and connected to the second region through the column selection lines disposed in the second region.
